# EUROPEAN PATENT APPLICATION

(11) **EP 4 395 287 A1**
(43) Date of publication of application: **03.07.2024**
(21) Application number: 23748934.9
(22) Date of filing: 12.07.2023
(51) Int. Cl.: H04M 1/02, H05K 5/02, H05K 9/00

(54) **ELECTRONIC DEVICE COMPRISING MULTI-FUNCTIONAL MEMBERS**

(30) Priority: 10.11.2022 KR 20220149688; 14.12.2022 KR 20220174444
(71) Applicant: Samsung Electronics Co., Ltd., Suwon-si, Gyeonggi-do 16677 (KR)
(72) Inventor: SHIN, Kwangha, Suwon-si, Gyeonggi-do 16677 (KR); LEE, Geuna, Suwon-si, Gyeonggi-do 16677 (KR); KIM, Donghak, Suwon-si, Gyeonggi-do 16677 (KR); KIM, Sangbae, Suwon-si, Gyeonggi-do 16677 (KR); PARK, Kiman, Suwon-si, Gyeonggi-do 16677 (KR); PARK, Jaeyong, Suwon-si, Gyeonggi-do 16677 (KR); PARK, Hongbum, Suwon-si, Gyeonggi-do 16677 (KR); LEE, Kihee, Suwon-si, Gyeonggi-do 16677 (KR); LEE, Seulgi, Suwon-si, Gyeonggi-do 16677 (KR); LIM, Hyosang, Suwon-si, Gyeonggi-do 16677 (KR); JUNG, Jeeyoung, Suwon-si, Gyeonggi-do 16677 (KR); CHOE, Sunjong, Suwon-si, Gyeonggi-do 16677 (KR)
(74) Representative: HGF
(86) International application number: PCT/KR2023/009927
(87) International publication number: WO 2024/101577

(57) **Abstract**

According to an embodiment of the disclosure, an electronic device may be provided comprising: a housing; a bracket disposed inside the housing and comprising a plurality of through holes including a first through hole and a second through hole; a first conductive pattern disposed on the bracket; a second conductive pattern disposed on the bracket; and a plurality of multi-functional members at least partially visually exposed to an outside of the housing, wherein a first multi-functional member among the multi-functional members is disposed around the first through hole and is electrically connected to the first conductive pattern and the second conductive pattern, and wherein a second multi-functional member among the multi-functional members is disposed around the second through hole, is electrically connected to the second conductive pattern, and is not electrically connected to the first conductive pattern except via the first multi-functional member and/or at least one other multi-functional member among the multi-functional members. Other various embodiments are possible.

## Description

### [Technical Field]

An embodiment(s) of the disclosure relates to an electronic device, e.g., an electronic device including a multi-functional member.

### [Background Art]

With the development of information and communication technology and semiconductor technology, the distribution and use of various electronic devices is rapidly increasing. Recent electronic devices may output the stored information as sounds or images and may provide information desired by the user through wireless communication. As electronic devices are highly integrated, and high-speed, high-volume wireless communication becomes commonplace, an electronic device, such as a mobile communication terminal, is recently being equipped with various functions. For example, an electronic device comes with the integrated functionality, including an entertainment function, such as playing video games, a multimedia function, such as replaying music/videos, a communication and security function for mobile banking, and a scheduling and e-wallet function. As the carrying and use of compact and slim electronic devices become commonplace, users demand diversified and upgraded exterior design for electronic devices.

To diversify the exterior design of an electronic device that is carried and used routinely, various factors, such as material, shape, or surface treatment (e.g., color, surface hardness or surface roughness), may be combined. Synthetic resin materials are easy to color and shape and are useful for mass production, but they may be somewhat less mechanically strong and durable. Metal, ceramic, or glass materials may provide better mechanical properties than synthetic resin materials while providing visually or tactilely excellent texture, but may be more expensive to manufacture than synthetic resin materials. For example, when implementing the exterior design of an electronic device, the manufacturing process and cost of the material may be considered.

The above-described information may be provided as background for the purpose of helping understanding of the disclosure. No claim or determination is made as to whether any of the foregoing is applicable as prior art in relation to the disclosure.

### [Disclosure of Invention]

### [Solution to Problems]

According to an embodiment of the disclosure, an electronic device may comprise: a housing; a bracket disposed inside the housing and comprising a plurality of through holes including a first through hole and a second through hole; a first conductive pattern disposed on the bracket; a second conductive pattern disposed on the bracket; and a plurality of multi-functional members at least partially visually exposed to an outside of the housing, wherein a first multi-functional member among the multi-functional members is disposed around the first through hole and is electrically connected to the first conductive pattern and the second conductive pattern, and wherein a second multi-functional member among the multi-functional members is disposed around the second through hole, is electrically connected to the second conductive pattern, and is not electrically connected to the first conductive pattern except via the first multi-functional member and/or at least one other multi-functional member among the multi-functional members.

According to an embodiment of the disclosure, an electronic device may comprise a housing, a bracket providing through holes and disposed inside the housing, a first conductive pattern disposed on the bracket, a second conductive pattern disposed on the bracket, and multi-functional members disposed around any one of the through holes and at least partially visually exposed to an outside of the housing. In an embodiment, a first multi-functional member among the multi-functional members may be electrically connected to the first conductive pattern and the second conductive pattern, and a second multi-functional member among the multi-functional members may be electrically connected to the second conductive pattern and not electrically connected to the first conductive pattern.

According to an embodiment of the disclosure, an electronic device may comprise a housing, a communication module, a bracket providing through holes and disposed inside the housing, a first conductive pattern disposed on the bracket, a second conductive pattern disposed on the bracket, and multi-functional members disposed around any one of the through holes and at least partially visually exposed to an outside of the housing. In an embodiment, a first multi-functional member among the multi-functional members may be electrically connected to the communication module through the first conductive pattern to be configured to perform wireless communication, and a second multi-functional member among the multi-functional members may be electrically connected to a ground portion of the electronic device through the second conductive pattern and not electrically connected to the first conductive pattern.

### [Brief Description of Drawings]

The foregoing and other aspects, configurations, and/or advantages of an embodiment of the disclosure will be more apparent from the following detailed description taken in conjunction with the accompanying drawings.
FIG. 1 is a block diagram illustrating an electronic device in a network environment according to an embodiment of the disclosure;
FIG. 2 is a front perspective view illustrating an electronic device according to an embodiment of the disclosure;
FIG. 3 is a perspective view illustrating a rear surface of the electronic device of FIG. 2 according to an embodiment of the disclosure;
FIG. 4 is an exploded front perspective view illustrating the electronic device of FIG. 2, according to an embodiment of the disclosure;
FIG. 5 is a rear exploded perspective view illustrating the electronic device of FIG. 2 according to an embodiment of the disclosure;
FIG. 6 is an exploded perspective view illustrating a portion of an electronic device according to an embodiment of the disclosure;
FIG. 7 is an exploded perspective view illustrating an arrangement of a multi-functional member(s) in an electronic device according to an embodiment of the disclosure;
FIG. 8 is a plan view illustrating an outer surface of a bracket for disposing a multi-functional member in an electronic device according to an embodiment of the disclosure;
FIG. 9 is a plan view illustrating an inner surface of a bracket for disposing a multi-functional member in an electronic device according to an embodiment of the disclosure;
FIG. 10 is a view of an assembly taken along line A-A' of FIG. 9 in an electronic device according to an embodiment of the disclosure;
FIG. 11 is an enlarged view illustrating a portion of a bracket for disposing a multi-functional member in an electronic device according to an embodiment of the disclosure;
FIG. 12 is a perspective view illustrating a multi-functional member of an electronic device according to an embodiment of the disclosure;
FIG. 13 is a perspective view illustrating a state in which a multi-functional member of an electronic device is disposed on a bracket according to an embodiment of the disclosure;
FIG. 14 is a plan view illustrating an inner surface of a bracket for disposing a multi-functional member in an electronic device according to an embodiment of the disclosure;
FIG. 15 is a view of an assembly taken along line B-B' of FIG. 14 in an electronic device according to an embodiment of the disclosure;
FIG. 16 is a perspective view illustrating a state in which a multi-functional member of an electronic device is disposed on a bracket according to an embodiment of the disclosure;
FIG. 17 is a view of an assembly taken along line C-C' of FIG. 16 in an electronic device according to an embodiment of the disclosure;
FIG. 18 is a view illustrating a conductive pattern(s) of an electronic device according to an embodiment of the disclosure;
FIG. 19 is a perspective view illustrating a state in which a conductive pattern(s) of an electronic device is disposed on a bracket according to an embodiment of the disclosure;
FIG. 20 is a perspective view illustrating a state in which a conductive pattern(s) of an electronic device is disposed on a bracket according to an embodiment of the disclosure;
FIG. 21 is a plan view illustrating an outer surface of a bracket for disposing a multi-functional member in an electronic device according to an embodiment of the disclosure;
FIG. 22 is a plan view illustrating an inner surface of a bracket for disposing a multi-functional member in an electronic device according to an embodiment of the disclosure;
FIG. 23 is a view of an assembly taken along line D-D' of FIG. 21 in an electronic device according to an embodiment of the disclosure;
FIG. 24 is a plan view illustrating an outer surface of a bracket for disposing a multi-functional member in an electronic device according to an embodiment of the disclosure; and
FIG. 25 is a view of a assembly taken along line E-E' of FIG. 24 in an electronic device according to an embodiment of the disclosure.

Throughout the drawings, like reference numerals may be assigned to like parts, components, and/or structures.

### [Mode for the Invention]

To downsize for portability, an electronic device may be more densely integrated. For example, as the space for placing various electronic components becomes narrower, and integration increases, the operating environment of the electronic device may worsen due to the heat generated by the electronic components. As the space for placing electronic components shrinks, it may be difficult to secure stable sound quality or wireless communication performance. Furthermore, as communication functions according to various protocols are implemented in one electronic device, the operating environment of the plurality of antennas may become harsh and electromagnetic interference with other electronic components may increase.

An embodiment of the disclosure, which is intended to at least address the foregoing issues and/or disadvantages and to provide the advantages described below, may provide an electronic device including a multi-functional member that may address the foregoing issues while providing a protective function and/or an aesthetically pleasing appearance.

An embodiment of the disclosure may provide an electronic device including a multi-functional member that implements a stable wireless communication environment while providing a protective function and/or an aesthetically pleasing appearance.

An embodiment of the disclosure may provide an electronic device including a multi-functional component that may suppress electromagnetic interference between antennas or electronic components while providing a protective function and/or an aesthetically pleasing appearance.

Objects of the disclosure are not limited to the foregoing, and other unmentioned objects would be apparent to one of ordinary skill in the art from the following description.

The following description taken in conjunction with the accompanying drawings may provide an understanding of various exemplary implementations of the disclosure, including claims and their equivalents. The specific embodiments disclosed in the following description entail various specific details to aid understanding, but are regarded as one of various embodiments. Accordingly, it will be understood by those skilled in the art that various changes and modifications may be made to the various implementations described in the disclosure without departing from the scope and spirit of the disclosure. Further, descriptions of well-known functions and configurations may be omitted for clarity and brevity.

The terms and words used in the following description and claims are not limited to the bibliographical meaning, but may be used to clearly and consistently describe an embodiment of the disclosure. Therefore, it will be apparent to those skilled in the art that the following description of various implementations of the disclosure is provided only for the purpose of description, not for the purpose of limiting the disclosure defined as the scope of the claims and equivalent thereto.

The singular forms "a," "an," and "the" are intended to include the plural forms as well, unless the context clearly indicates otherwise. Thus, as an example, "a component surface" may be interpreted as including one or more of the surfaces of a component.

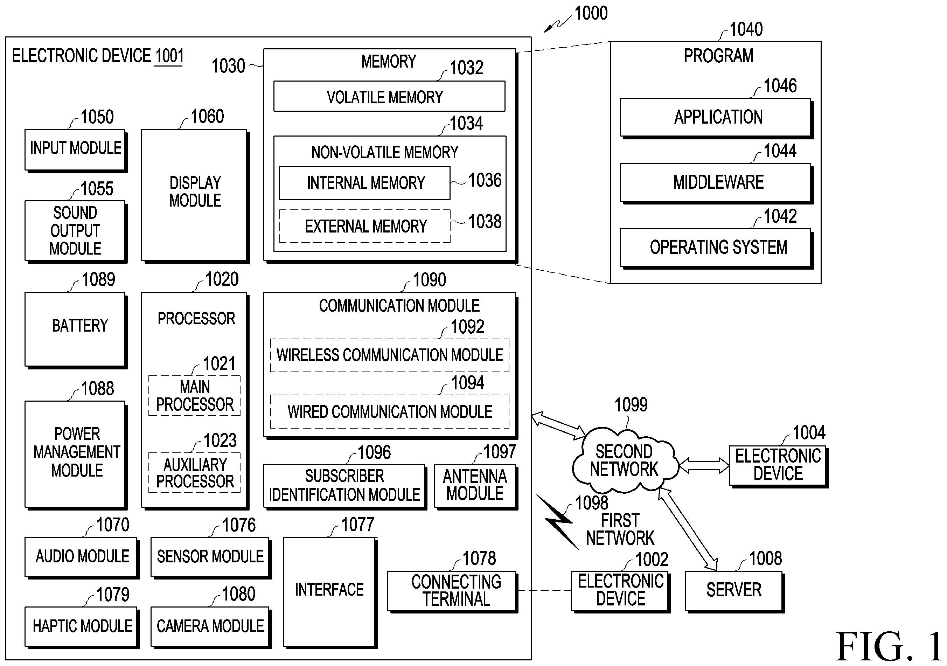

FIG. 1 is a block diagram illustrating an electronic device 1001 in a network environment 1000 according to an embodiment of the disclosure. Referring to FIG. 1, the electronic device 1001 in the network environment 1000 may communicate with at least one of an electronic device 1002 via a first network 1098 (e.g., a short-range wireless communication network), or an electronic device 1004 or a server 1008 via a second network 1099 (e.g., a long-range wireless communication network). According to an embodiment, the electronic device 1001 may communicate with the electronic device 1004 via the server 1008. According to an embodiment, the electronic device 1001 may include a processor 1020, memory 1030, an input module 1050, a sound output module 1055, a display module 1060, an audio module 1070, a sensor module 1076, an interface 1077, a connecting terminal 1078, a haptic module 1079, a camera module 1080, a power management module 1088, a battery 1089, a communication module 1090, a subscriber identification module (SIM) 1096, or an antenna module 1097. In an embodiment, at least one (e.g., the connecting terminal 1078) of the components may be omitted from the electronic device 1001, or one or more other components may be added in the electronic device 101. According to an embodiment, some (e.g., the sensor module 1076, the camera module 1080, or the antenna module 1097) of the components may be integrated into a single component (e.g., the display module 1060).

The processor 1020 may execute, for example, software (e.g., a program 1040) to control at least one other component (e.g., a hardware or software component) of the electronic device 1001 coupled with the processor 1020, and may perform various data processing or computation. According to one embodiment, as at least part of the data processing or computation, the processor 1020 may store a command or data received from another component (e.g., the sensor module 1076 or the communication module 1090) in volatile memory 1032, process the command or the data stored in the volatile memory 1032, and store resulting data in non-volatile memory 1034. According to an embodiment, the processor 1020 may include a main processor 1021 (e.g., a central processing unit (CPU) or an application processor (AP)), or an auxiliary processor 1023 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 1001 includes the main processor 1021 and the auxiliary processor 1023, the auxiliary processor 1023 may be configured to use lower power than the main processor 1021 or to be specified for a designated function. The auxiliary processor 1023 may be implemented as separate from, or as part of the main processor 1021.

The auxiliary processor 1023 may control at least some of functions or states related to at least one component (e.g., the display module 1060, the sensor module 1076, or the communication module 1090) among the components of the electronic device 1001, instead of the main processor 1021 while the main processor 1021 is in an inactive (e.g., sleep) state, or together with the main processor 1021 while the main processor 1021 is in an active state (e.g., executing an application). According to an embodiment, the auxiliary processor 1023 (e.g., an image signal processor or a communication processor) may be implemented as part of another component (e.g., the camera module 1080 or the communication module 1090) functionally related to the auxiliary processor 123. According to an embodiment, the auxiliary processor 1023 (e.g., the neural processing unit) may include a hardware structure specified for artificial intelligence model processing. The artificial intelligence model may be generated via machine learning. Such learning may be performed, e.g., by the electronic device 1001 where the artificial intelligence is performed or via a separate server (e.g., the server 1008). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 1030 may store various data used by at least one component (e.g., the processor 1020 or the sensor module 1076) of the electronic device 1001. The various data may include, for example, software (e.g., the program 1040) and input data or output data for a command related thereto. The memory 1030 may include the volatile memory 1032 or the non-volatile memory 1034.

The program 1040 may be stored in the memory 1030 as software, and may include, for example, an operating system (OS) 1042, middleware 1044, or an application 1046.

The input module 1050 may receive a command or data to be used by other component (e.g., the processor 1020) of the electronic device 1001, from the outside (e.g., a user) of the electronic device 1001. The input module 1050 may include, for example, a microphone, a mouse, a keyboard, keys (e.g., buttons), or a digital pen (e.g., a stylus pen).

The sound output module 1055 may output sound signals to the outside of the electronic device 1001. The sound output module 1055 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 1060 may visually provide information to the outside (e.g., a user) of the electronic device 1001. The display 1060 may include, for example, a display, a hologram device, or a projector and control circuitry to control a corresponding one of the display, hologram device, and projector. According to an embodiment, the display 1060 may include a touch sensor configured to detect a touch, or a pressure sensor configured to measure the intensity of a force generated by the touch.

The audio module 1070 may convert a sound into an electrical signal and vice versa. According to an embodiment, the audio module 1070 may obtain the sound via the input module 1050, or output the sound via the sound output module 1055 or a headphone of an external electronic device (e.g., the electronic device 1002) directly (e.g., wiredly) or wirelessly coupled with the electronic device 1001.

The sensor module 1076 may detect an operational state (e.g., power or temperature) of the electronic device 1001 or an environmental state (e.g., a state of a user) external to the electronic device 101, and then generate an electrical signal or data value corresponding to the detected state. According to an embodiment, the sensor module 1076 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 1077 may support one or more specified protocols to be used for the electronic device 1001 to be coupled with the external electronic device (e.g., the electronic device 1002) directly (e.g., wiredly) or wirelessly. According to an embodiment, the interface 1077 may include, for example, a high definition multimedia interface (HDMI), a universal serial bus (USB) interface, a secure digital (SD) card interface, or an audio interface.

A connecting terminal 1078 may include a connector via which the electronic device 1001 may be physically connected with the external electronic device (e.g., the electronic device 1002). According to an embodiment, the connecting terminal 1078 may include, for example, a HDMI connector, a USB connector, a SD card connector, or an audio connector (e.g., a headphone connector).

The haptic module 1079 may convert an electrical signal into a mechanical stimulus (e.g., a vibration or motion) or electrical stimulus which may be recognized by a user via his tactile sensation or kinesthetic sensation. According to an embodiment, the haptic module 1079 may include, for example, a motor, a piezoelectric element, or an electric stimulator.

The camera module 1080 may capture a still image or moving images. According to an embodiment, the camera module 1080 may include one or more lenses, image sensors, image signal processors, or flashes.

The power management module 1088 may manage power supplied to the electronic device 1001. According to one embodiment, the power management module 1088 may be implemented as at least part of, for example, a power management integrated circuit (PMIC).

The battery 1089 may supply power to at least one component of the electronic device 1001. According to an embodiment, the battery 1089 may include, for example, a primary cell which is not rechargeable, a secondary cell which is rechargeable, or a fuel cell.

The communication module 1090 may support establishing a direct (e.g., wired) communication channel or a wireless communication channel between the electronic device 1001 and the external electronic device (e.g., the electronic device 1002, the electronic device 1004, or the server 1008) and performing communication via the established communication channel. The communication module 1090 may include one or more communication processors that are operable independently from the processor 1020 (e.g., the application processor (AP)) and supports a direct (e.g., wired) communication or a wireless communication. According to an embodiment, the communication module 1090 may include a wireless communication module 1092 (e.g., a cellular communication module, a short-range wireless communication module, or a global navigation satellite system (GNSS) communication module) or a wired communication module 1094 (e.g., a local area network (LAN) communication module or a power line communication (PLC) module). A corresponding one of these communication modules may communicate with the external electronic device via a first network 1098 (e.g., a short-range communication network, such as BluetoothTM, wireless-fidelity (Wi-Fi) direct, or infrared data association (IrDA)) or a second network 1099 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 1092 may identify or authenticate the electronic device 1001 in a communication network, such as the first network 1098 or the second network 1099, using subscriber information (e.g., international mobile subscriber identity (IMSI)) stored in the subscriber identification module 1096.

The wireless communication module 1092 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 1092 may support a high-frequency band (e.g., the mmWave band) to achieve, e.g., a high data transmission rate. The wireless communication module 1092 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 1092 may support various requirements specified in the electronic device 1001, an external electronic device (e.g., the electronic device 1004), or a network system (e.g., the second network 1099). According to an embodiment, the wireless communication module 1092 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 1097 may transmit or receive a signal or power to or from the outside (e.g., the external electronic device). According to an embodiment, the antenna module may include an antenna including a radiator formed of a conductor or conductive pattern formed on a substrate (e.g., a printed circuit board (PCB)). According to an embodiment, the antenna module 1097 may include a plurality of antennas (e.g., an antenna array). In this case, at least one antenna appropriate for a communication scheme used in a communication network, such as the first network 1098 or the second network 1099, may be selected from the plurality of antennas by, e.g., the communication module 1090. The signal or the power may then be transmitted or received between the communication module 1090 and the external electronic device via the selected at least one antenna. According to an embodiment, other parts (e.g., radio frequency integrated circuit (RFIC)) than the radiator may be further formed as part of the antenna module 1097.

According to an embodiment, the antenna module 1097 may form a mmWave antenna module. According to an embodiment, the mm Wave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, instructions or data may be transmitted or received between the electronic device 1001 and the external electronic device 1004 via the server 1008 coupled with the second network 1099. The external electronic devices 1002 or 1004 each may be a device of the same or a different type from the electronic device 1001. According to an embodiment, all or some of operations to be executed at the electronic device 1001 may be executed at one or more of the external electronic devices 1002, 1004, or 1008. For example, if the electronic device 1001 should perform a function or a service automatically, or in response to a request from a user or another device, the electronic device 1001, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1001. The electronic device 1001 may provide the outcome, with or without further processing of the outcome, as at least part of a reply to the request. To that end, a cloud computing, distributed computing, mobile edge computing (MEC), or client-server computing technology may be used, for example. The electronic device 1001 may provide ultra low-latency services using, e.g., distributed computing or mobile edge computing. In an embodiment, the external electronic device 1004 may include an internet-of-things (IoT) device. The server 1008 may be an intelligent server using machine learning and/or a neural network. According to an embodiment, the external electronic device 1004 or the server 1008 may be included in the second network 1099. The electronic device 1001 may be applied to intelligent services (e.g., smart home, smart city, smart car, or healthcare) based on 5G communication technology or IoT-related technology.

The electronic device according to embodiment(s) of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

An embodiment(s) of the disclosure and terms used therein are not intended to limit the technical features described in the disclosure to specific embodiments, and should be understood to include various modifications, equivalents, or substitutes of the embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program) including one or more instructions that are stored in a storage medium (e.g., internal memory or external memory) that is readable by a machine (e.g., the electronic device). For example, a processor (e.g., the processor) of the machine (e.g., the electronic device) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play StoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to embodiments, each component (e.g., a module or a program) of the above-described components may include a single entity or multiple entities. Some of the plurality of entities may be separately disposed in different components. According to embodiments, one or more of the above-described components may be omitted, or one or more other components may be added. Alternatively or Further, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to embodiments, operations performed by the module, the program, or another component may be carried out sequentially, in parallel, repeatedly, or heuristically, or one or more of the operations may be executed in a different order or omitted, or one or more other operations may be added.

As used herein, the term 'through hole' denotes a hole extending from one surface of a component to another surface of the component, such that light and/or objects may pass through the component via the through hole.

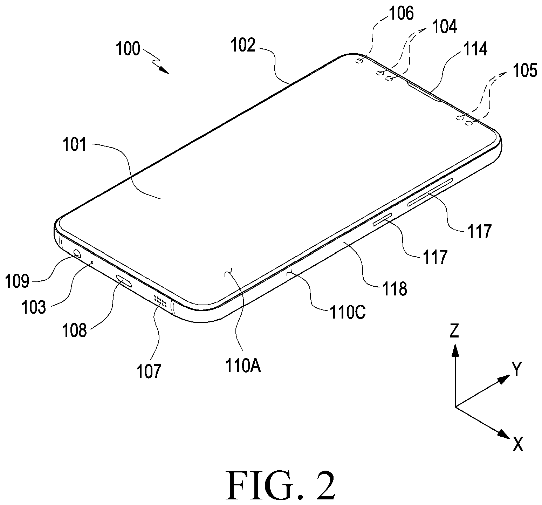

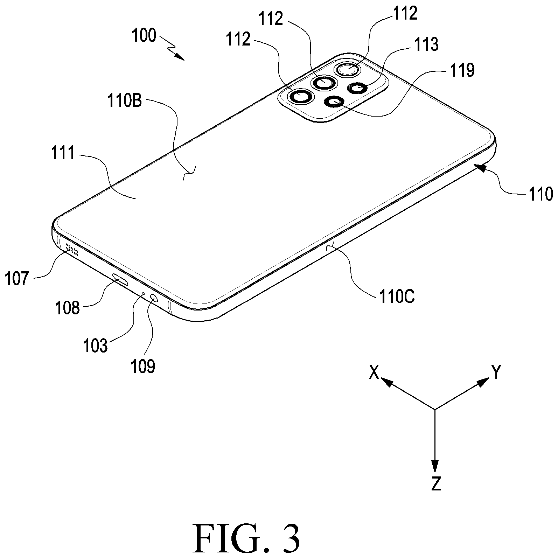

FIG. 2 is a front perspective view illustrating an electronic device 100 according to an embodiment of the disclosure. FIG. 3 is a perspective view illustrating a rear surface of the electronic device 100 of FIG. 2 according to an embodiment of the disclosure.

Referring to FIGS. 2 and 3, according to an embodiment, an electronic device 100 (e.g., the electronic device 1001 of FIG. 1) may include a housing 110 including a first surface (or front surface) 110A, a second surface (or rear surface) 110B, and a side surface 110C surrounding a space between the first surface 110A and the second surface 110B. According to an embodiment (not shown), the housing 110 may denote a structure forming the first surface 110A of FIG. 2, the second surface 110B of FIG. 3, and some of the side surfaces 110C. According to an embodiment, at least part of the first surface 110A may have a substantially transparent front plate 102 (e.g., a glass plate or polymer plate including various coat layers). The second surface 110B may be formed of a substantially opaque rear plate 111. The rear plate 111 may be formed of, e.g., laminated or colored glass, ceramic, polymer, metal (e.g., aluminum, stainless steel (STS), or magnesium), or a combination of at least two thereof. The side surface 110C may be formed by a side structure (or a "side bezel structure") 118 that couples to the front plate 102 and the rear plate 111 and includes a metal and/or polymer. In an embodiment, the rear plate 111 and the side structure 118 may be integrally formed together and include the same material (e.g., a metal, such as aluminum).

Although not shown, the front plate 102 may include area(s) that bend from at least a portion of an edge toward the rear plate 111 and seamlessly extend. In an embodiment, only one of the areas of the front plate 102 (or the rear plate 111), which bend to the rear plate 111 (or front plate 102) and extend may be included in one edge of the first surface 110A. According to an embodiment, the front plate 102 or the rear plate 111 may have a substantially flat plate shape. For example, no bent and extended area may be included. When an area bending and extending is included, the thickness of the electronic device 100 at the portion including the area bending and extending may be smaller than the thickness of the rest.

According to an embodiment, the electronic device 100 may include at least one of a display 101, an audio module (e.g., the microphone hole 103, the external speaker hole 107, and the phone receiver hole 114), a sensor module (e.g., the first sensor module 104, the second sensor module (not illustrated), or the third sensor module 119), a camera module (e.g., the first camera device 105, the second camera device 112, or the flash 113), a key input device 117, a light emitting device 106, and a connector hole (e.g., the first connector hole 108 or the second connector hole 109). In an embodiment, the electronic device 100 may exclude at least one (e.g., the key input device 117 or the light emitting device 106) of the components or may add other components.

The display 101 may output a screen or be visually exposed through a significant portion of the first surface 110A (e.g., the front plate 102), for example. In an embodiment, at least a portion of the display 101 may be visually exposed through the front plate 102 forming the first surface 110A, or through a portion of the side surface 110C. In an embodiment, the edge of the display 101 may be formed to be substantially the same in shape as an adjacent outer edge of the front plate 102. In an embodiment (not shown), the interval between the outer edge of the display 101 and the outer edge of the front plate 102 may remain substantially even to give a larger area of visual exposure of the display 101.

In an embodiment (not shown), a recess or an opening may be formed in a portion of the screen display area of the display 101, and there may be included at least one of an audio module (e.g., the phone receiver hole 114), a sensor module (e.g., the first sensor module 104), a camera module (e.g., the first camera device 105), and a light emitting device 106 that are aligned with the recess or the opening. In an embodiment (not shown), at least one of the audio module (e.g., the phone receiver hole 114), sensor module (e.g., the first sensor module 104), camera module (e.g., the first camera device 105), fingerprint sensor (not shown), and light emitting device 106 may be included on the rear surface of the screen display area of the display 101. In an embodiment (not shown), the display 101 may be disposed to be coupled with, or adjacent, a touch detecting circuit, a pressure sensor capable of measuring the strength (pressure) of touches, and/or a digitizer for detecting a magnetic field-type stylus pen. In an embodiment, when the front plate 102 or the rear plate 111 includes a bent and extended area(s), at least some of the sensor modules (e.g., the first sensor module 104 and the third sensor module 119) and/or at least some of the key input devices 117 may be disposed in the bent and extended area(s).

The audio modules 103, 107, and 114 may include a microphone hole 103 and speaker holes (e.g., the external speaker hole 107 and the phone receiver hole 114). A microphone for acquiring external sounds may be disposed in the microphone hole 103. In an embodiment, a plurality of microphones may be disposed to detect the direction of the sound. The speaker holes may include an external speaker hole 107 and a phone receiver hole 114. According to an embodiment, the speaker holes (e.g., the external speaker hole 107 and the phone receiver hole 114) and the microphone hole 103 may be implemented as a single hole, or speakers may be included without the speaker holes (e.g., the external speaker hole 107 and the phone receiver hole 114) (e.g., piezo speakers).

The sensor module may generate an electrical signal or data value corresponding to an internal operating state or external environmental state of the electronic device 100. The sensor modules may include a first sensor module 104 (e.g., a proximity sensor) and/or a second sensor module (not shown) (e.g., a fingerprint sensor) disposed on the first surface 110A of the housing 110 and/or a third sensor module 119 disposed on the second surface 110B of the housing 110. The second sensor module (not shown) (e.g., a fingerprint sensor) may be disposed on the second surface 110B or side surface 110C as well as the first surface 110A (e.g., the display 101) of the housing 110. The electronic device 100 may further include, e.g., at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

The camera modules may include a first camera device 105 disposed on the first surface 110A of the electronic device 100, and a second camera device 112 and/or a flash 113 disposed on the second surface 110B. The camera devices (e.g., the first camera device 105 and the second camera device 112) may include one or more lenses, an image sensor, and/or an image signal processor. The flash 113 may include, e.g., a light emitting diode (LED) or a xenon lamp. In an embodiment, one or more lenses (an infrared (IR) camera, a wide-angle lens, and a telephoto lens) and image sensors may be disposed on one surface of the electronic device 100. In an embodiment, flash 113 may emit infrared light. The infrared light emitted by the flash 113 and reflected by the subject may be received through the third sensor module 119. The electronic device 100 or the processor (e.g., the processor 1020 of FIG. 1) of the electronic device 100 may detect depth information about the subject based on the time point when the infrared light is received from the third sensor module 119.

The key input device 117 may be disposed on the side surface 110C of the housing 110. In an embodiment, the electronic device 100 may exclude all or some of the above-mentioned key input devices 117 and the excluded key input devices 117 may be implemented in other forms, e.g., as soft keys, on the display 101. In an embodiment, the key input device may include the sensor module disposed on the second surface 110B of the housing 110.

The light emitting device 106 may be disposed on, e.g., the first surface 110A of the housing 110. The light emitting device 106 may provide, e.g., information about the state of the electronic device 100 in the form of light. In an embodiment, the light emitting device 106 may provide a light source that interacts with, e.g., the camera module (e.g., the first camera device 105). The light emitting device 106 may include, e.g., a light emitting diode (LED), an infrared (IR) LED, or a xenon lamp.

The connector holes (e.g., the first connector hole 108 or the second connector hole 109) may include, e.g., a first connector hole 108 for receiving a connector (e.g., a USB connector) for transmitting/receiving power and/or data to/from an external electronic device (e.g., the electronic device 1002 of FIG. 1) and/or a second connector hole 109 (e.g., an earphone jack) for receiving a connector for transmitting/receiving audio signals to/from the external electronic device.

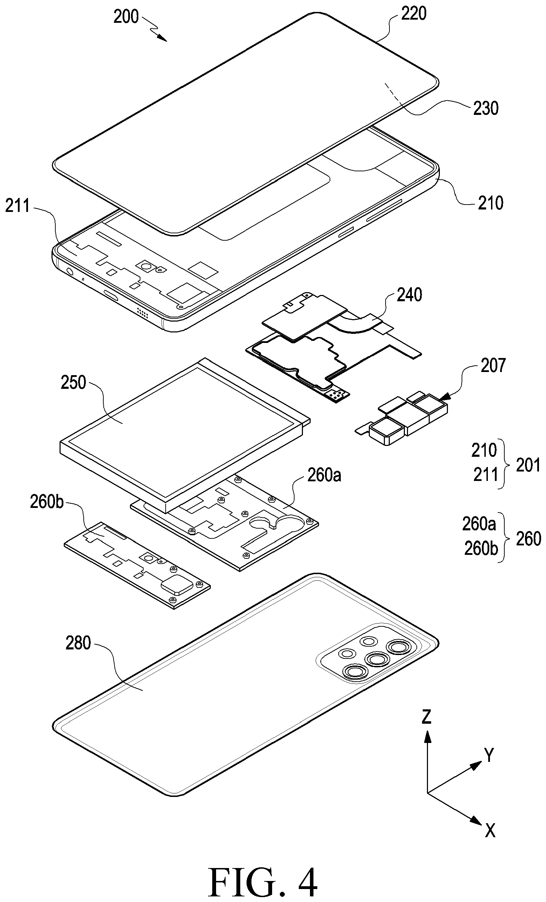

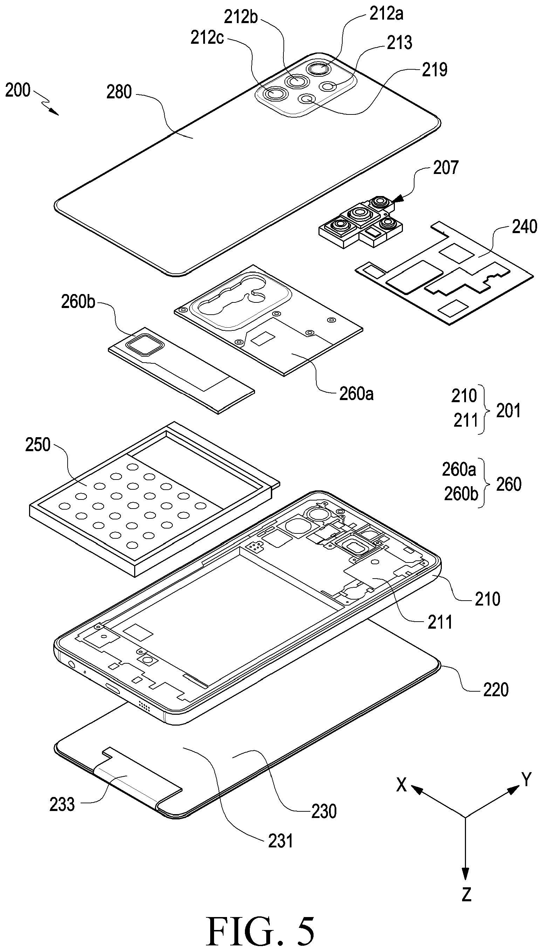

FIG. 4 is an exploded front perspective view illustrating the electronic device 200 of FIG. 2, according to an embodiment of the disclosure. FIG. 5 is a rear exploded perspective view illustrating the electronic device 200 of FIG. 2 according to an embodiment of the disclosure.

Referring to FIGS. 4 and 5, an electronic device 200 (e.g., the electronic device 1001, 1002, 1004, or 100 of FIG. 1, 2, or 3) may include a side structure 210, a first supporting member 211 (e.g., a bracket), a front plate 220 (e.g., the front plate 102 of FIG. 1), a display 230 (e.g., the display 101 of FIG. 1), a printed circuit board (or a board assembly) 240, a battery 250, a second supporting member 260 (e.g., a rear case), an antenna, a camera assembly 207, and a rear plate 280 (e.g., the rear plate 111 of FIG. 3). In an embodiment, the electronic device 200 may exclude at least one (e.g., the first supporting member 211 or the second supporting member 260) of the components or may add other components. At least one of the components of the electronic device 200 may be the same or similar to at least one of the components of the electronic device 100 of FIG. 2 or 3 and no duplicate description is made below.

The first supporting member 211 may be disposed inside the electronic device 200 to be connected with the side surface structure 210 or integrated with the side surface structure 210. The first supporting member 211 may be formed of, e.g., a metal and/or non-metallic material (e.g., polymer). When at least partially formed of a metallic material, a portion of the side structure 210 or the first supporting member 211 may function as an antenna. The display 230 may be joined onto one surface of the first supporting member 211, and the printed circuit board 240 may be joined onto the opposite surface of the first supporting member 232. A processor (e.g., the processor 1020 of FIG. 1), a memory (e.g., the memory 1030 of FIG. 1), and/or an interface (e.g., the interface 1077 of FIG. 1) may be mounted on the printed circuit board 240. The processor may include one or more of, e.g., a central processing unit, an application processor, a graphic processing device, an image signal processing, a sensor hub processor, or a communication processor.

According to various embodiments, the first supporting member 211 and the side structure 210 may be collectively referred to as a front case or a housing 201. According to an embodiment, the housing 201 may be generally understood as a structure for receiving, protecting, or disposing the printed circuit board 240 or the battery 250. In an embodiment, the housing 201 may be understood as including a structure that the user may visually or tactfully recognize from the exterior of the electronic device 200, e.g., the side structure 210, the front plate 220, and/or the rear plate 280. In an embodiment, the 'front or rear surface of the housing 201' may mean the first surface 110A of FIG. 2 or the second surface 110B of FIG. 3. In an embodiment, the first supporting member 211 may be disposed between the front plate 220 (e.g., the first surface 110A of FIG. 2) and the rear plate 280 (e.g., the second surface 110B of FIG. 3) and may function as a structure for placing an electrical/electronic component, such as the printed circuit board 240 or the camera assembly 207.

The display 230 may include a display panel 231 and a flexible printed circuit board 233 extending from the display panel 231. It may be understood that the flexible printed circuit board 233 is, e.g., electrically connected to the display panel 231 while at least partially disposed on the rear surface of the display panel 231. In an embodiment, reference number '231' may be understood as a protective sheet disposed on the rear surface of the display panel. For example, the protective sheet may be understood as a portion of the display panel 231 unless otherwise designated in the detailed description below. In an embodiment, the protective sheet may function as a cushioning structure that absorbs external force (e.g., a low-density elastic material, such as a sponge) or an electromagnetic shielding structure (e.g., a copper sheet (CU sheet)). According to an embodiment, the display 230 may be disposed on the inner surface of the front plate 220 and, by including a light emitting layer, output a screen through at least a portion of the front plate 220 or the first surface 110A of FIG. 2. As mentioned above, the display 230 may output substantially the entire area of the front plate 220 or the first surface 110A of FIG. 2.

The memory may include, e.g., a volatile or non-volatile memory.

The interface may include, e.g., a high definition multimedia interface (HDMI), a universal serial bus (USB) interface, a secure digital (SD) card interface, and/or an audio interface. The interface may electrically or physically connect, e.g., the electronic device 200 with an external electronic device and may include a USB connector, an SD card/multimedia card (MMC) connector, or an audio connector.

The second supporting member 260 may include, e.g., an upper supporting member 260a and a lower supporting member 260b. In an embodiment, the upper supporting member 260a, together with a portion of the first supporting member 211, may be disposed to surround the printed circuit board 240. A circuit device (e.g., a processor, a communication module, or a memory) implemented in the form of an integrated circuit chip or various electrical/electronic components may be disposed on the printed circuit board 240. According to an embodiment, the printed circuit board 240 may receive an electromagnetic shielding environment from the upper supporting member 260a. In an embodiment, the lower supporting member 260b may be utilized as a structure in which electrical/electronic components, such as a speaker module and an interface (e.g., a USB connector, an SD card/MMC connector, or an audio connector) may be disposed. In an embodiment, electrical/electronic components, such as a speaker module and an interface (e.g., a USB connector, an SD card/MMC connector, or an audio connector) may be disposed on an additional printed circuit board (not shown). For example, the lower supporting member 260b, together with the other part of the first supporting member 211, may be disposed to surround the additional printed circuit board. A speaker module or interface disposed on an additional printed circuit board (not shown) or lower supporting member 260b may be disposed corresponding to the connector hole (e.g., the first connector hole 108 or the second connector hole 109) or the audio module (e.g., the microphone hole 103 or the speaker hole (e.g., the external speaker hole 107 or the phone receiver hole 114)) of FIG. 2.

The battery 250 may be a device for supplying power to at least one component of the electronic device 200. The battery 450 may include, e.g., a primary cell which is not rechargeable, a secondary cell which is rechargeable, or a fuel cell. At least a portion of the battery 250 may be disposed on substantially the same plane as the printed circuit board 240. The battery 250 may be integrally or detachably disposed inside the electronic device 200.

Although not shown, the antenna may include a conductor pattern implemented on the surface of the second supporting member 260 through, e.g., laser direct structuring (LDS). In an embodiment, the antenna may include a printed circuit pattern formed on the surface of the thin film. The thin film-type antenna may be disposed between the rear plate 280 and the battery 250. The antenna may include, e.g., a near-field communication (NFC) antenna, a wireless charging antenna, and/or a magnetic secure transmission (MST) antenna. The antenna may perform short-range communication with, e.g., an external device or may wirelessly transmit or receive power necessary for charging. In an embodiment of the present invention, another antenna structure may be formed by a portion or combination of the side structure 210 and/or the first supporting member 211.

The camera assembly 207 may include at least one camera module. Inside the electronic device 200, the camera assembly 207 may receive at least a portion of the light incident through the optical hole or the camera windows 212a, 212b, 212c, 213, and 219. In an embodiment, the camera assembly 207 may be disposed on the first supporting member 211 in a position adjacent to the printed circuit board 240. In an embodiment, the camera module(s) of the camera assembly 207 may be generally aligned with either one of the camera windows 212a, 212b, 212c, 213, and 219 and be a least partially surrounded by the second supporting member 260 (e.g., the upper supporting member 260a).

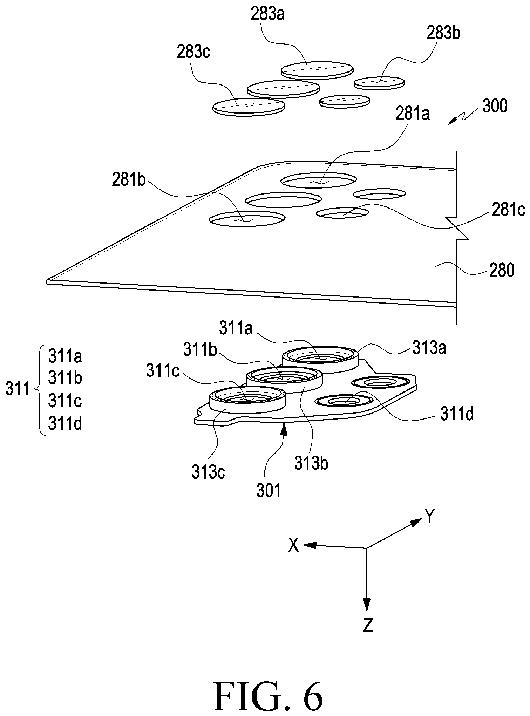

FIG. 6 is an exploded perspective view illustrating a portion of an electronic device (e.g., the electronic device 1001, 1002, 1004, 100, or 200 of FIGS. 1 to 5) according to an embodiment of the disclosure.

FIG. 6 illustrates an assembly 300 disposed on the exterior of an electronic device (e.g., the electronic device 200 of FIG. 4 or 5) in an area corresponding to the camera assembly 207 of FIG. 4 or 5. Referring to FIG. 6, the assembly 300 may include a plate-shaped bracket 301 that provides a plurality of through holes 311 (e.g., 311a, 311b, 311c, and 311d), and may be disposed inside the rear plate 280 (e.g., the rear plate 280 of FIG. 4 or 5) or the housing (e.g., the housing 201 of FIG. 4 or 5). In an embodiment, the assembly 300 may be provided as a portion of the rear plate 280, and it should be noted that the structure of the present embodiment regarding the assembly 300 does not limit the present disclosure.

According to an embodiment, the bracket 301 may be disposed inside the rear plate 280 in the state in which the through hole(s) 311 are aligned with the opening area(s) 281 provided in the rear plate 280, and window members 283a, 283b, and 283c (e.g., the camera windows 212a, 212b, 212c, 213, and 219 of FIG. 5) may be disposed to correspond to any one of the through holes 311 to close the opening area(s) 281 and/or the through hole(s) 311. For example, the opening area(s) 281 of the rear plate 280 may be closed or sealed by a combination of the bracket 301 and the window members 283a, 283b, and 283c. For example, a first through hole 311a may be aligned with a first opening area 281a, and a first window member 283a may be configured to close the first opening area 281a and/or the first through hole 311a. A second through hole 311b may be aligned with a second opening area 281b, and a second window member 283b may be configured to close the second opening area 281b and/or the second through hole 311b. A third through hole 311c may be aligned with a third opening area 281c, and a third window member 283c may be configured to close the third opening area 281c and/or the third through hole 311c. It will be understood that this is merely an example, and that the disclosure is not limited to three through holes, window members, and/or opening areas. In an embodiment, at least a portion of the bracket 301 and/or the camera windows 212a, 212b, 212c, 213, and 219 may be visually exposed to the external space through the opening area(s) 281. In an embodiment, the camera assembly 207 may obtain a subject image by receiving incident light through the camera windows 212a, 212b, 212c, 213, and 219 and/or the window members 283a, 283b, and 283c. In an embodiment, the camera assembly 207 may include a plurality of cameras having different optical specifications such as focal length and/or angle of view, and the electronic device 200 or a processor (e.g., the processor 1020 of FIG. 1) of the electronic device 200 may generate a high-quality image by synthesizing images obtained from the plurality of cameras.

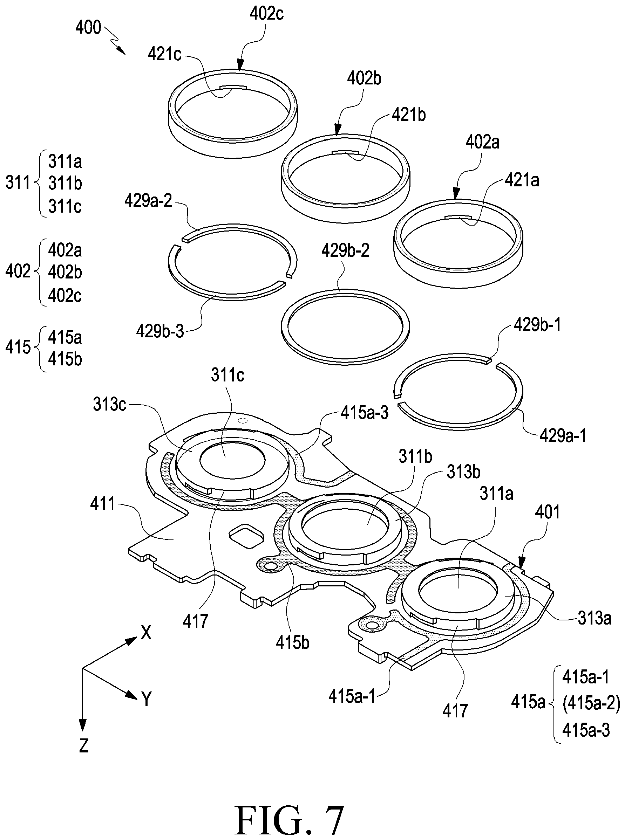

According to an embodiment, the electronic device 200 and/or the bracket 301 may include protrusions or binding rib(s) 313a, 313b, and 313c protruding from one surface of the bracket 301. The binding rib(s) 313a, 313b, and 313c may be formed, e.g., around one or more of the through holes 311. For example, a first binding rib 313a may be formed around first through hole 311a, a second binding rib 313b may be formed around a second through hole 311b, and/or a third binding rib 313c may be formed around a third through hole 313c. It will be understood that this is merely an example, and that the disclosure is not limited to three through holes and/or three binding ribs. In an embodiment, the binding ribs 313a, 313b, and 313c may not be disposed around at least one of the through holes 311 (e.g., the through hole indicated by reference numeral "311d"). That is, there may be at least one through hole without a corresponding binding rib. When the bracket 301 is disposed inside the rear plate 280, the binding rib(s) 313a, 313b, and 313c may be at least partially received in the opening area(s) 281. For example, first binding rib 313a may be at least partially received in first opening area 281a, second binding rib 313b may be at least partially received in second opening area 281b, and third binding rib 313c may be at least partially received in third opening area 281c. It will be understood that this is merely an example, and that the disclosure is not limited to three binding ribs and/or opening areas. For example, in the state of being received in the opening area(s) 281, the binding rib(s) 313a, 313b, and 313c may be visually exposed to the external space. In an embodiment, when a portion of the bracket 301 is visually exposed to the external space, the material, shape, or color of the exposed portion may implement a decorative effect on the exterior of the electronic device 200. As is described below, the binding rib(s) 313a, 313b, and 313c may function as a structure for binding the multi-functional member(s) (e.g., the multi-functional member 402 of FIG. 7). In an embodiment, the multi-functional member(s) 402 may be disposed on the bracket 301 by insert injection molding, and for example, the binding ribs 313a, 313b, and 313c may be omitted.

According to an embodiment, the through holes 311 may be disposed adj acent to each other on the bracket 301. For example, among the through holes 311, a first through hole 311a, a second through hole 311b, and a third through hole 311c may be sequentially arranged in one direction (e.g., the Y-axis direction of FIG. 5 or the longitudinal direction of the electronic device 200). The number, arrangement, or spacing of the through holes 311 may be appropriately changed according to specifications required by the electronic device 200, and the positions of the cameras included in the camera assembly 207 may be considered in determining the number, arrangement, or spacing of the through holes 311. In the illustrated embodiment, it should be noted that the through holes 311 or the window members 283a, 283b, and 283c have a substantially circular shape, but the embodiment(s) of the disclosure are not limited thereto. For example, when the camera assembly 207 includes a light source emitting infrared rays or a lighting, a through hole or a window member corresponding to the light source may have an elliptical or polygonal shape.

In the following detailed description, the electronic device 200 or the assembly 300 of the preceding embodiment may be referred to, and the components that may be easily understood through the preceding embodiment may be denoted by the same reference numerals in the drawings or omitted, and the detailed description thereof may also be omitted. The above-described configuration of the embodiment may be applied in understanding the configuration omitted from the detailed description of the embodiment to be described below. The term 'conductive pattern' may refer to a conducting line or a printed circuit formed through a process such as printing, etching, or laser processing, but it should be noted that the 'conductive pattern' mentioned in the embodiment(s) of the disclosure is not limited thereto. In describing embodiments(s) of the disclosure, 'conductive pattern' may refer to any conductive material or any conductive object disposed on a surface of an insulating material (e.g., synthetic resin), and may be understood to include, e.g., an LDS pattern, a conductive tape, a conductive gasket, a conductive plate member, and/or a conductive leaf spring.

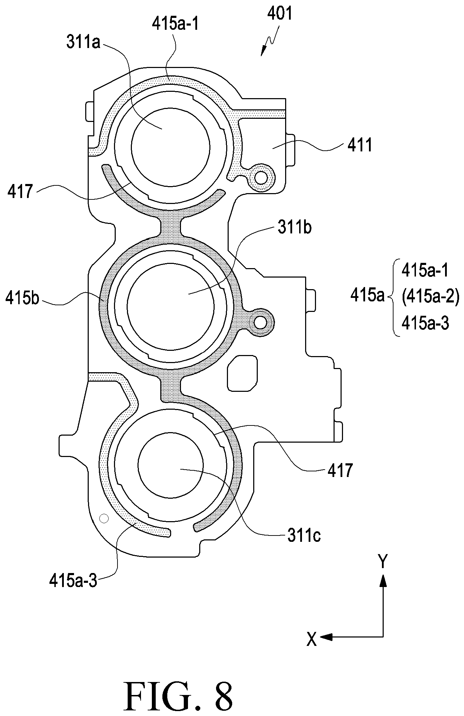

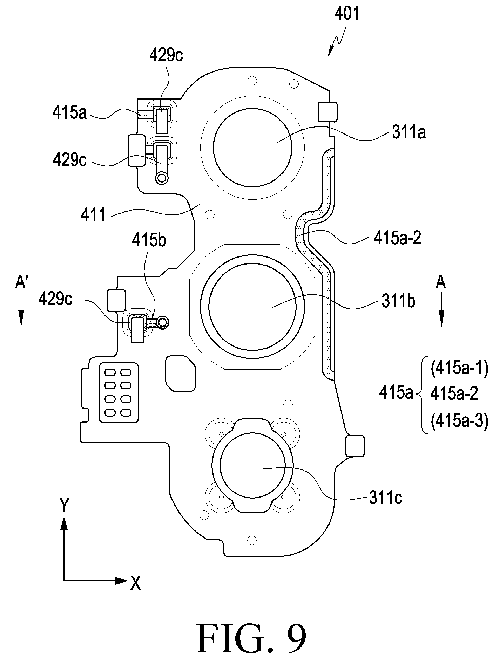

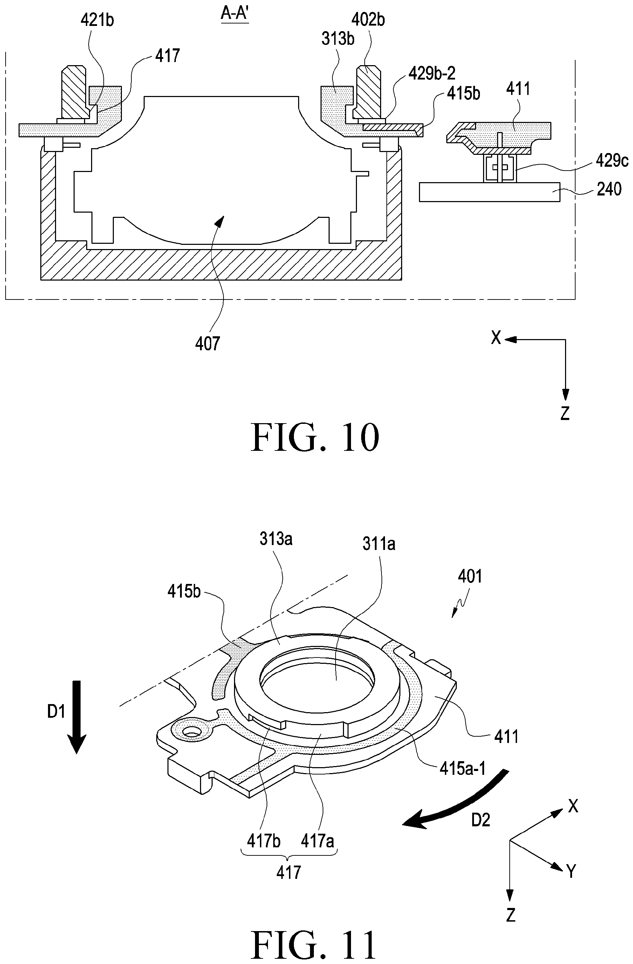

FIG. 7 is an exploded perspective view illustrating an arrangement of at least one multi-functional member 402 in an electronic device (e.g., the electronic devices 1001, 1002, 1004, 100, and 200 of FIGS. 1 to 5) according to an embodiment. FIG. 8 is a plan view illustrating an outer surface of a bracket 401 for disposing a multi-functional member 402 in an electronic device 200 according to an embodiment of the disclosure. FIG. 9 is a plan view illustrating an inner surface of a bracket 401 for disposing a multi-functional member 402 in an electronic device 200 according to an embodiment of the disclosure. FIG. 10 is a view illustrating an assembly 400 taken along line A-A' of FIG. 9 in an electronic device 200 according to an embodiment of the disclosure. FIG. 11 is an enlarged view illustrating a portion of a bracket 401 for disposing a multi-functional member 402 in an electronic device 200 according to an embodiment of the disclosure.

Referring to FIGS. 7 to 11, the electronic device 200 and/or the assembly 400 (e.g., the assembly 300 of FIG. 6) may include a bracket 401, conductive patterns 415, and multi-functional members 402. In an embodiment, some of the multi-functional members 402 may be electrically connected to each of the conductive patterns 415, and others of the multi-functional members 402 may be electrically connected to at least one of the conductive patterns 415 and may not be electrically connected to another one of the conductive patterns 415. In an embodiment, the electronic device 200 may include a housing (e.g., the housing 201, the front plate 220, and/or the rear plate 280 of FIG. 4 or 5) that receives the assembly 400, and the multi-functional member(s) 402 may be at least partially visually exposed to the outside of the electronic device 200 or the housing 201.

According to an embodiment, some (e.g., the first multi-functional member 402a and the third multi-functional member 402c) of the multi-functional members 402 may be electrically connected to a communication module (e.g., the communication module 1090 of FIG. 1) of the electronic device and may be configured to transmit and receive wireless signals. In an embodiment, at least some of the multi-functional members 402 may be electrically connected to the ground portion of the electronic device 200 to discharge static electricity accumulated in the exterior of the electronic device 200 to the ground portion. Here, the term "ground portion of the electronic device" may include, e.g., a ground conductor provided in a circuit board (e.g., the printed circuit board 240 of FIG. 4 or 5) or various structures (e.g., the first supporting member 211 of FIG. 4 or 5) inside the electronic device 200.

As such, the multi-functional member(s) 402 according to an embodiment(s) of the disclosure may be may be utilized as an antenna and/or to discharge static electricity. Furthermore, the multi-functional member(s) 402 may be visually exposed to the exterior of the electronic device 200 to implement a decorative effect. Still further, the multi-functional members may improve the mechanical properties of the electronic device by providing a structure to strengthen the electronic device in the vicinity of a through hole. According to an embodiment, when two or more multi-functional members 402 are electrically connected to the communication module 1090, the multi-functional member 402 (e.g., the second multi-functional member 402b) electrically connected to the ground portion without being electrically connected to the communication module 1090 (or without being directly or substantially directly electrically connected to the communication module) may be disposed between the antennas (e.g., the multi-functional members 402 connected to the communication module 1090). For example, the multi-functional member (e.g., the second multi-functional member 402b) electrically connected to the ground portion may function as a structure that secures a designated interval or suppresses electromagnetic interference between the multi-functional members (e.g., the first multi-functional member 402a and the third multi-functional member 402c) performing wireless communication. However, the embodiment(s) of the disclosure are not limited thereto, and the connection relationship with the communication module 1090 and/or the ground portion and the arrangement of the plurality of multi-functional members may be changed according to the specifications required by the electronic device 200.

According to an embodiment, the bracket 401 may include a base plate 411 and a binding rib(s) (e.g., the binding ribs 313a, 313b, and 313c of FIG. 6), and may provide holes (e.g., the through hole 311 of FIG. 6) passing through two opposite surfaces of the base plate 411. In an embodiment, the binding rib(s) 313a, 313b, and 313c may be disposed to surround a circumference of at least one of the through holes 311 and may protrude from one surface of the base plate 411. In an embodiment, the binding rib(s) 313a, 313b, and 313c may function as a structure for disposing or securing the multi-functional member(s) 402 on the bracket 401 or the base plate 411, and when a manufacturing method such as insert injection molding or adhesion is utilized, the multi-functional member 402 may be coupled to the bracket 401 without the binding rib(s) 313a, 313b, and 313c. In an embodiment, the binding rib(s) 313a, 313b, and 313c are provided regardless of the manufacturing method, so that the multi-functional member 402 may be more stably coupled to the bracket 401. In an embodiment, the through holes 311 may substantially provide a path through which external light is incident into the inside of the electronic device 200 (e.g., the camera assembly 207 of FIG. 5), and any one or more of the through holes 311 may provide a path through which light output from a light source inside the housing 201 is radiated to the outside.

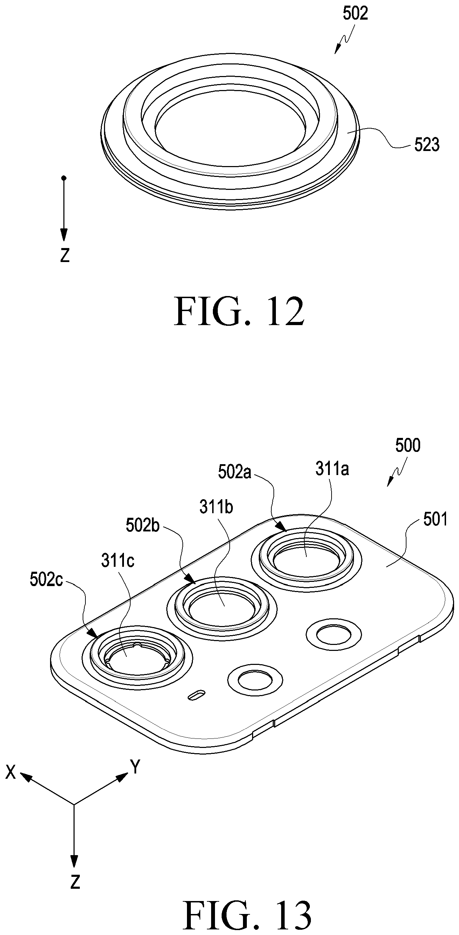

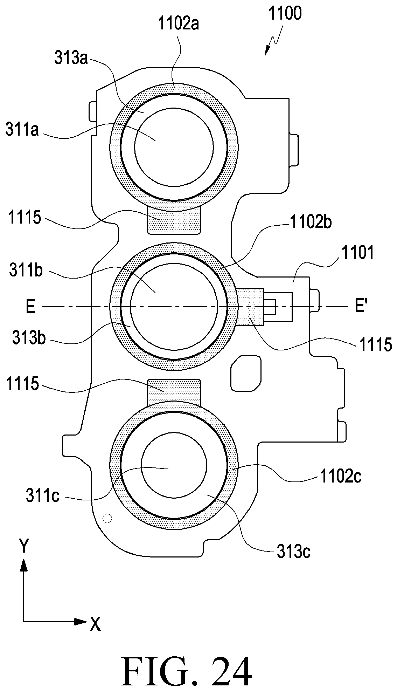

According to an embodiment, the electronic device 200 and/or the assembly 400 may include conductive patterns 415 (415a and 415b) disposed on the bracket 401. The conductive patterns 415 may be, for example, patterns formed by laser direct structuring (hereinafter, referred to as 'LDS patterns'). In an embodiment, the conductive patterns 415 may be implemented as a conductive tape, a conductive gasket, and/or a conductive plate member. In an embodiment, the conductive patterns 415 may be replaced with a flange (e.g., the flange 523 of FIG. 12) or a contact piece (e.g., the contact piece 1115 of FIG. 24) extending from the multi-functional member 402. Implementation examples of the conductive patterns 415 are further described through the embodiment(s) described below, and it should be noted that the conductive patterns 415 are not limited to the configurations mentioned in the present embodiment as long as an electrical connection path may be implemented.

According to an embodiment, among the conductive patterns 415, a first conductive pattern 415a (415a-1, 415a-2, and 415a-3) may be disposed from one surface to the other surface of the base plate 411. For example, a portion of the first conductive pattern 415a, indicated by "415a-1", may be disposed substantially around the first through hole 311a on one surface of the base plate 411, and a portion of the first conductive pattern 415a, indicated by "415a-3", may be disposed substantially around the third through hole 311c on one surface of the base plate 411. In an embodiment, the portion of the first conductive pattern 415a, indicated by "415a-2", may be disposed on the other surface of the base plate 411 and may connect the portion indicated by "415a-1" and the portion indicated by "415a-3". For example, the portion of the first conductive pattern 415a, indicated by "415a-2", may be disposed near or substantially around the second through hole 311b on the other surface of the base plate 411, and may connect the portion indicated by "415a-1" and the portion indicated by "415a-3". For example, one end of the portion indicated by "415a-2" may be electrically connected to the portion indicated by "415a-1", and another end may be electrically connected to the portion indicated by "415a-3". In an embodiment, when the first conductive pattern 415a is disposed from one surface to the other surface of the base plate 411, the first conductive pattern 415a may be partially disposed on a side surface of the base plate 411 in order to electrically connect a portion of the first conductive pattern 415a on one surface to a portion of the first conductive pattern 415a on the other (e.g. opposite) surface. When a structure such as a via hole is provided in the base plate 411, the first conductive patterns 415a disposed on two different surfaces (e.g., an inner surface and an outer surface) of the base plate 411 may be electrically connected through the via hole.

According to an embodiment, the second conductive pattern 415b among the conductive patterns 415 may be electrically separated from the first conductive pattern 415a, and may extend from one surface of the base plate 411 to the other surface. For example, the second conductive pattern 415b may be partially disposed on a side surface of the base plate 411 in order to electrically connect a portion of the first conductive pattern 415a on one surface to a portion of the first conductive pattern 415a on the other (e.g. opposite) surface. When a structure such as a via hole is provided in the base plate 411, the second conductive patterns 415b disposed on two different surfaces of the base plate 411 may be electrically connected through the via hole. In the illustrated embodiment, the second conductive patterns 415b may be disposed on two different surfaces of the base plate 411 and may be electrically connected through the via hole. In an embodiment, a portion of the conductive patterns 415 disposed on the inner surface of the base plate 411 may function as an electrical connection structure with a circuit board (e.g., the printed circuit board 240 of FIG. 4 or FIG. 5). That is, the portion of the conductive patterns 415 disposed on the inner surface of the base plate 411 may be configured to electrically connect the conductive patterns 415 to the circuit board (e.g., the printed circuit board 240 of FIG. 4 or FIG. 5). The portion of the conductive patterns 415 that functions as an electrical connection structure is described again below.

According to an embodiment, on one surface (e.g., the outer surface) of the base plate 411, the first conductive pattern 415a (e.g., the portions indicated by "415a-1" and "415a-3") may be disposed on a portion of the circumference of the first through hole 311a and/or a portion of the circumference of the third through hole 311c. In an embodiment, a portion (e.g., the portion indicated by "415a-2") of the first conductive pattern 415a may be disposed on the other surface of the base plate 411 and may electrically connect the portions indicated by "415a-1" and "415a-3". In an embodiment, a portion of the first conductive pattern 415a disposed on the other surface of the base plate 411 may electrically connect portions (e.g., the portions indicated by "415a-1" and "415a-3") disposed in the first through hole 311a and the third through hole 311c, bypassing the second conductive pattern 415b, as described below.

According to an embodiment, on one surface of the base plate 411, the second conductive pattern 415b may be disposed on another portion of the circumference of the first through hole 311a and/or another portion of the circumference of the third through hole 311c. In an embodiment, the second conductive pattern 415b may be disposed around substantially the entire circumference of the second through hole 311b. For example, on one surface of the base plate 411, the second conductive pattern 415b may be disposed on another portion of the circumference of the first through hole 311a, the substantially entire circumference of the second through hole 311b, and/or another portion of the circumference of the third through hole 311c. In an embodiment, when the second conductive pattern 415b is disposed around the second through hole 311b and thus the area in which the first conductive pattern 415a may be disposed is limited on one surface of the base plate 411, a portion of the first conductive pattern 415a is disposed on the other surface (e.g., the inner surface) of the base plate 411 so that the first conductive pattern 415a may be substantially implemented in the form of one conductive wire or one conductive line.

According to an embodiment, the multi-functional members 402 may include a first multi-functional member 402a disposed to correspond to the first through hole 311a, a second multi-functional member 402b disposed to correspond to the second through hole 311b, and/or a third multi-functional member 402c disposed to correspond to the third through hole 311c. When expressed to be disposed to correspond to an n-th through hole, it may mean that an n-th multi-functional member is disposed to surround at least a portion of the circumference of the n-th through hole. In an embodiment, the multi-functional member(s) 402 may have a loop shape or a ring shape corresponding to the shape of the through hole(s) 311. In an embodiment, the multi-functional member(s) 402 may have a substantially closed loop shape. In an embodiment, regardless of the shape of the through hole 311, the multi-functional members 402 may have an elliptical or polygonal shape, and the shapes of the multi-functional members 402 may vary depending on the exterior design of the electronic device 200 to be implemented.

According to an embodiment, the multi-functional members 402 may be disposed on the bracket 401 and may be electrically connected to at least one of the conductive patterns 415. For example, the multi-functional members 402 may include a conductive material (e.g., metal), and the at least one multi-functional member(s) 402 may be electrically connected to a communication module (e.g., the communication module 1090 of FIG. 1) and/or a ground portion (e.g., the ground conductor or the first supporting member 211 provided in the printed circuit board 240 of FIG. 4 or 5) through the conductive patterns 415. In an embodiment, at least one of the multi-functional members 402 including a conductive material may function as an antenna by being electrically connected to the communication module 1090. For example, a stable wireless communication environment may be provided by utilizing the multi-functional member(s) 402 visually exposed to the external space as an antenna. According to an embodiment, the multi-functional members 402 may be electrically connected to at least the ground portion to discharge static electricity that may be accumulated in an actual use environment to the ground portion (e.g., the ground conductor or the first supporting member 211 provided in the printed circuit board 240 of FIG. 4 or FIG. 5). For example, the multi-functional members 402 may be electrically connected to the ground portion to suppress an electrostatic discharge that is unpredicted or irregular. Accordingly, it is possible to suppress electric shock to the user and/or damage or malfunction of electronic components that may be caused by static electricity.

In an embodiment, the multi-functional members 402 may improve the mechanical properties of the electronic device 200 by providing a reinforcing structure surrounding at least portions of the through holes. For example, when the multi-functional members 402 are formed of a metallic material, the reinforcing effect may be even greater because of the mechanical properties of the metallic material.

In an embodiment, when the multi-functional members 402 are formed of a metallic material and are visually exposed to the outer space, a decorative effect may be applied to the exterior (e.g., the circumference of the through hole 311 or the opening area 281 of FIG. 6) of the electronic device 200.

Previously, "at least one of the multi-functional members 402 is electrically connected to the communication module 1090" may refer to substantially the first conductive pattern 415a being electrically connected to the communication module 1090. That is, at least one of the multi-functional member 402 may be electrically connected to the communication module 1090 via the first conductive pattern 415a. For example, since the first conductive pattern 415a is not disposed around the second through hole 311b on one surface of the base plate 411, the first conductive pattern 415a may not be electrically directly connected to the second multi-functional member 402b, and the first multi-functional member 402a and the third multi-functional member 402c may be substantially directly connected to the first conductive pattern 415a (and/or the communication module 1090). That is, the first multi-functional member 402a and the third multi-functional member 402c may make direct electrical contact with the first conductive pattern 415a, or may make a substantially direct electrical connection to the first conductive pattern 415a via, for example, a conductive adhesive or a first connection member 429, as described in more detail below. Furthermore, the first conductive pattern 415a may not be electrically connected to the second multi-functional member 402b, except, in some embodiments, via the first multi-functional member 402a and/or the third multi-functional member 402c. That is, in some embodiments in which at least one of the first multi-functional member 402a and/or the third multi-functional member 404c are electrically connected to the second conductive pattern 415b, although there is no direct electrical contact or substantially direct electrical connection (e.g. via a conductive adhesive or a first connection member 429) between the first conductive pattern 415a and the second multi-functional member 402b, there may exist an indirect electrical connection between the first conductive pattern 415a and the second multi-functional member via the first/third multi-functional member 402a/402c and the second conductive pattern 415b. However, in other embodiments, the first conductive pattern and second conductive pattern may be electrically isolated. For example, there may be no multi-functional members electrically connected to both the first conductive pattern and the second conductive pattern, or the multi-functional members may be configured to comprise a first portion electrically connected to the first conductive pattern and a second portion electrically connected to the second conductive pattern, wherein the second portion is electrically isolated from the first portion. In an embodiment, 'the multi-functional members 402 are electrically connected to at least the ground portion (among the communication module 1090 and the ground portion)' may refer to substantially the second conductive pattern 415b being electrically connected to the ground portion. That is, at least one of, and in some embodiments all of, the multi-functional members 402 may be electrically connected to the ground portion via the second conductive pattern 415b. For example, the second conductive pattern 415b may be disposed around each of the first through hole 311a, the second through hole 311b, and/or the third through hole 311c and may electrically connect the multi-functional members 402 to the ground portion.

According to an embodiment, in a structure in which the first through hole 311a, the second through hole 311b, and the third through hole 311c are sequentially disposed along one direction, when the first multi-functional member 402a and the third multi-functional member 402c are electrically connected to the communication module 1090, the second multi-functional member 402b may be disposed between the first multi-functional member 402a and the third multi-functional member 402c. For example, the second multi-functional member 402b may provide a designated interval between the first multi-functional member 402a and the third multi-functional member 402c, which function as an antenna, thereby suppressing electromagnetic interference between the first multi-functional member 402a and the third multi-functional member 402c. Accordingly, when the first multi-functional member 402a and the third multi-functional member 402c function as antennas, a stable wireless communication environment may be provided.

According to an embodiment, the assembly 400 may further include first connection member(s) 429a-1, 429a-2, 429b-1, 429b-2, and 429b-3 disposed between and configured to electrically connect the multi-functional members 402 and the conductive pattern(s) 415. The first connection members 429a-1, 429a-2, 429b-1, 429b-2, and 429b-3 may be disposed between, e.g., the multi-functional members 402 and the conductive patterns 415, thereby stably maintaining an electrical coupling state (or an electrical connection state). In an embodiment, the first connection members 429a-1, 429a-2, 429b-1, 429b-2, and 429b-3 may include a conductive adhesive or a low-density elastic body (e.g., a conductive gasket) including a conductive material. For example, when the multi-functional members 402 are disposed on the bracket 401, the first connection members 429a-1, 429a-2, 429b-1, 429b-2, and 429b-3 may be partially compressed to come in tight contact with the multi-functional member(s) 402 and/or the conductive pattern(s) 415. In the illustrated embodiment, the first connection member (e.g., the 1-1th connection member) indicated by reference numeral "429a-1" may electrically connect the first conductive pattern 415a (e.g. the first portion 415a-1) and the multi-functional member 402 (e.g., the first multi-functional member 402a), and the first connection member (e.g., the 1-2th connection member) indicated by "429a-2" may electrically connect the first conductive pattern 415a (e.g. the third portion 415a-3) and the multi-functional member 402 (e.g., the third multi-functional member 402c). In an embodiment, the first connection member (e.g., the 1-3th connection member) indicated by reference numeral "429b-1" may electrically connect the second conductive pattern 415b and the multi-functional member 402 (e.g., the first multi-functional member 402a), the first connection member (e.g., the 1-4th connection member) indicated by reference numeral "429b-2" may electrically connect the second conductive pattern 415b and the multi-functional member 402 (e.g., the second multi-functional member 402b), and/or the first connection member (e.g., the 1-5th connection member) indicated by reference numeral "429b-3" may electrically connect the second conductive pattern 415b and the multi-functional member 402 (e.g., the third multi-functional member 402c). In an embodiment, the first connection members 429a-1, 429a-2, 429b-1, 429b-2, and 429b-3 may be implemented as another structure such as a conductive tape or a leaf spring.

According to an embodiment, when the multi-functional member(s) 402 are disposed on the bracket 401, the electronic device 200 and/or the multi-functional assembly 400 may further include binding recess(es) 417 provided in the binding ribs 313a, 313b, and 313c, and binding protrusion(s) 421a, 421b, and 421c provided in the multi-functional member(s) 402. The binding recess(es) 417 may be disposed, for example, on the outer circumferential surface of the binding ribs 313a, 313b, and 313c. In an embodiment, the binding recess(es) 417 may include a first guide recess 417a extending from the upper end of the binding ribs 313a, 313b, and 313c toward the base plate 411 (e.g., in the direction of arrow D1 in FIG. 11), and a second guide recess 417b extending from the first guide recess 417a in the circumferential direction of the through hole 311 (e.g., in the direction of arrow D2 in FIG. 11) at a position adjacent to the base plate 411. For example, the binding recess(es) 417 may be shaped as the letter 'L'. In an embodiment, a plurality of binding recesses 417 may be disposed in one binding rib 313a, 313b, and 313c, and the plurality of binding recesses 417 may be arranged at equiangular intervals along the circumferential direction of the through hole 311.

According to an embodiment, the binding protrusions 421a, 421b, and 421c may protrude inward (e.g., in the radial direction of the through hole 311) from the inner circumferential surface of the multi-functional member 402. The multi-functional member 402 may move in the direction of arrow D1 in a state in which the binding protrusions 421a, 421b, and 421c are aligned with the first guide recess 417a to get closer to the base plate 411 and, by rotating in the direction of arrow D2 in a state in which the binding protrusions 421a, 421b, and 421c are aligned with the second guide recess 417b, may enter the second guide recess 417b. In a state in which the binding protrusions 421a, 421b, and 421c enter the second guide recess 417b, the multi-functional member 402 may be prevented from moving in the reverse direction of arrow D1. For example, as the binding protrusions 421a, 421b, and 421c enter the second guide recess 417b, the multi-functional member 402 may be substantially bound to the binding ribs 313a, 313b, and 313c and/or the bracket 401. In an embodiment, when the first connection members 429a-1, 429a-2, 429b-1, 429b-2, and 429b-3 are implemented with an elastic body such as a conductive gasket and the multi-functional member 402 is bound to the bracket 401, the first connection members 429a-1, 429a-2, 429b-1, 429b-2, and 429b-3 may be partially compressed. For example, the first connection members 429a-1, 429a-2, 429b-1, 429b-2, and 429b-3 may accumulate an elastic force while being compressed, thereby bringing the coupling protrusions 421a, 421b, and 421c into tight contact with the inner wall of the second guide recess 417b. Accordingly, when the first connection members 429a-1, 429a-2, 429b-1, 429b-2, and 429b-3 are provided as elastic bodies, the multi-functional member 402 may maintain a more stable state of being bound to the binding ribs 313a, 313b, and 313c and/or the bracket 401.

According to an embodiment, the electronic device 200 and/or the assembly 400 may further include a second connection member 429c disposed inside the bracket 401. The second connection member 429c may electrically connect, for example, the conductive patterns 415 to a circuit board (e.g., the printed circuit board 240 of FIG. 4 or FIG. 5 or a ground conductor provided in the printed circuit board 240). In an embodiment, at least one second connection member 429c electrically connected to the first conductive pattern 415a and another second connection member 429c electrically connected to the second conductive pattern 415b may be provided. In an embodiment, the second connection member 429c may include a conductive gasket, a conductive tape, or a leaf spring (e.g., a C-clip). The second connection member 429c may be disposed on at least one of, for example, the bracket 401 and the printed circuit board 240, and may electrically connect the conductive patterns 415 to the printed circuit board 240 when the bracket 401 and the printed circuit board 240 are disposed in the housing 201. In an embodiment, if allowed in the inner space of the housing 201, the second connection member 429c may directly connect the second conductive pattern 415b to the first supporting member 211.

According to an embodiment, the camera module 407 (e.g., the camera assembly 207 of FIG. 4 or 5) may be disposed on or inside the assembly 400. For example, at least one camera (e.g., a wide-angle camera, a telephoto camera, a close-up camera, and/or a depth camera) included in the camera assembly 207 or the camera module 407 may be disposed to correspond to at least one of the through holes 311. For example, the camera assembly 207 or the camera module 407 may include a first camera (e.g., a telephoto camera, a close-up camera, or a depth camera) that receives external light through the first through hole 311a or the third through hole 311c, and may include a second camera (e.g., a wide-angle camera) that receives external light through the second through hole 311b. As mentioned above, the first multi-functional member 402a and the third multi-functional member 402c corresponding to the first through hole 311a or the third through hole 311c may be electrically connected to the communication module 1090 and/or the ground portion, and the second multi-functional member 402b corresponding to the second through hole 311b may be electrically connected to the ground portion but may not be electrically connected to the communication module 1090 (except, in some embodiments, via the first multi-functional member 402a and/or the third multi-functional member 402c). The presence of the multi-functional members 402 surrounding (or in the vicinity of) the through holes 311 may provide a protective structure to protect the cameras corresponding to the through holes from pressure or impact damage.

According to an embodiment, when compared with a telephoto camera or a close-up camera, a wide-angle camera may generate data having a higher speed and a larger capacity or may transmit the data to a processor (e.g., the processor 1020 of FIG. 1). For example, in generating data or transmitting and receiving data to and from the processor 1020, the wide-angle camera may be more vulnerable to electromagnetic interference than the telephoto camera or the close-up camera. In the electronic device 200 and/or the assembly 400 according to an embodiment(s) of the disclosure, a wireless communication function or a communication band may be expanded by utilizing the multi-functional member 402 as an antenna, and a multi-functional member (e.g., the second multi-functional member 402b) disposed corresponding to the wide-angle camera may be connected to the ground portion without being connected to the communication module 1090 (except, in some embodiments, via the other members connected to the communication module 1090 and the ground portion). For example, in utilizing the multi-functional members 402 as antennas, the electronic device 200 may suppress a decrease in the speed of data signal transmission and/or a decrease in wireless communication performance as the multi-functional member(s) disposed adjacent to an electronic component (e.g., a wide-angle camera) that transmits or processes high-speed/large-capacity data are not connected (e.g. not directly or substantially directly connected) to the communication module 1090. In an embodiment, the multi-functional member (e.g., the second multi-functional member 402b) not connected (e.g. not directly or substantially directly connected) to the communication module 1090 may be connected to the ground portion to discharge the accumulated static electricity to the ground conductor or the first supporting member 211 of the printed circuit board 240.

As described above, the electronic device 200 according to an embodiment(s) of the disclosure may include the multi-functional member(s) 402 formed of a conductive material (e.g., metal), thereby providing a stable electrostatic discharge path. For example, it is possible to suppress electric shock to the user or damage to electronic component(s) due to static electricity. In an embodiment, the electronic device 200 may easily expand a wireless communication function or a communication band by utilizing the multi-functional member(s) 402 as an antenna. In utilizing the multi-functional member(s) 402 as an antenna, the multi-functional member(s) adjacent to an electronic component that transmits or processes high-speed/large-capacity signals may not be connected to the communication module 1090 (except, in some embodiments, via the other members connected to the communication module 1090 and the ground portion), thereby stabilizing a data transmission environment or a wireless communication environment. Furthermore, the multi-functional members 402 including a conductive material (e.g. metal) may function as a stable electrostatic discharge path and/or antenna while also providing a reinforcing effect and/or an aesthetically pleasing appearance.

Other implementation examples of the above-described assembly (e.g., the assembly 300 or 400 of FIG. 6 or FIG. 7) are described with reference to FIGS. 12 to 25. In the following detailed description, the components that may be easily understood through the preceding embodiments are assigned the same reference numerals or are omitted, and the detailed description thereof may also be omitted. The above-described configuration of the embodiment may be applied in understanding the configuration omitted from the detailed description of the embodiment to be described below, and if necessary, the above-described configuration of the embodiment may be selectively combined with the configuration of the embodiment described below to implement additional embodiments. In particular, the above-described configuration in which a first and/or third multi-functional member is electrically connected to the first conductive pattern (and, optionally, the second conductive pattern) and the second multi-functional member is electrically connected to the second conductive pattern and not to the first conductive pattern (except, in some embodiments, via the first multi-functional member and/or the third multi-functional member) is applicable to all of the embodiments described below.

FIG. 12 is a perspective view illustrating a multi-functional member 502 (e.g., the multi-functional member 402 of FIG. 7) of an electronic device (e.g., the electronic device 1001, 1002, 1004, 100, or 200 of FIGS. 1 to 5) according to an embodiment of the disclosure. FIG. 13 is a perspective view illustrating a state in which a multi-functional member 502 of an electronic device 200 according to an embodiment is disposed on a bracket 501 (e.g., the bracket 401 of FIG. 7).

Referring to FIGS. 12 and 13, the assembly 500 and/or the multi-functional member 502 may include a flange 523 protruding radially from the outer circumferential surface of the multi-functional member 502. As compared to the preceding embodiment, the flange 523 may be utilized as a structure for expanding the contact area between the bracket 501 (or the base plate 411 of FIG. 7) and the multi-functional member 502 or coupling the multi-functional member 502 and the bracket 501 in a different form from that in the preceding embodiment. For example, the multi-functional member 502 and/or the flange 523 formed of a conductive material such as metal may be coupled to or mounted on the bracket 501 simultaneously with forming the bracket 501 by insert injection molding. In an embodiment, during insert injection molding, at least a portion of the flange 523 may be surrounded by the bracket 501 or may be embedded in the bracket 501. When the assembly 500 is manufactured by insert injection molding, the binding ribs 313a, 313b, and 313c of FIG. 7 may be omitted. However, the disclosure is not limited thereto, and the assembly 500 manufactured by insert injection molding may include a slit or slot formed in the multi-functional member 502 and, as a portion of the bracket 501 is cured inside the slit or slot during the forming process, the multi-functional member 502 and the bracket 501 may be more firmly coupled.

According to an embodiment, in the structure in which the assembly 500 is manufactured by insert injection molding, the first connection members 429a-1, 429a-2, 429b-1, 429b-2, and 429b-3 of FIG. 7 may be omitted. Although not shown, the assembly 500 of FIG. 13 may include conductive patterns (e.g., the conductive patterns 415 of FIG. 7) such as an LDS pattern, a conductive tape, and/or a conductive gasket, and the multi-functional member 502 may be electrically connected to the conductive patterns as described above in relation to the multi-functional member(s) 402 and conductive patterns 415. For example, a first multi-functional member 502a and/or a third multi-functional member 502c may be electrically connected to the first conductive pattern (and, optionally, the second conductive pattern) and a second multi-functional member 502b may be electrically connected to the second conductive pattern and not to the first conductive pattern (except, in some embodiments, via the first multi-functional member 502a and/or the third multi-functional member 502c). In an embodiment, when the conductive patterns are implemented in an LDS pattern, the conductive pattern and the multi-functional member may be electrically connected through an additional connection member (e.g., a conductive tape or a conductive gasket).

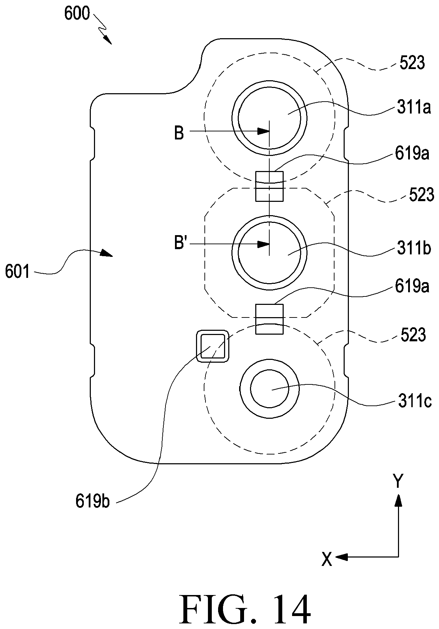

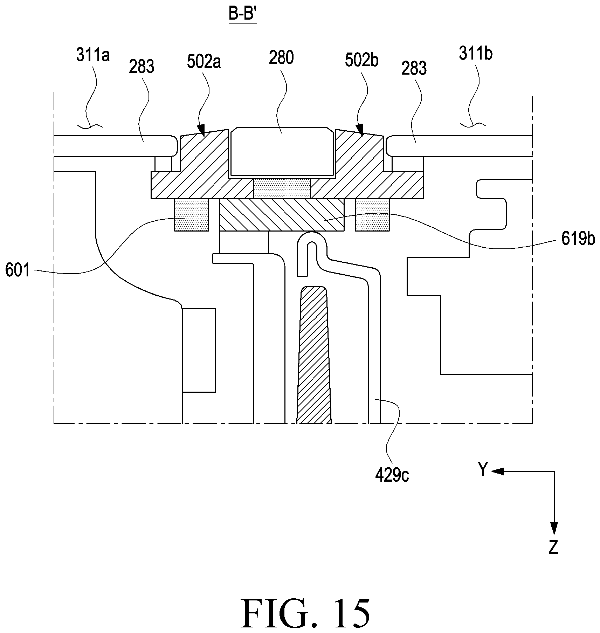

FIG. 14 is a plan view illustrating an inner surface of a bracket 601 (e.g., the bracket 401 or 501 of FIG. 7 or 13) for disposing multi-functional members 502a and 502b (e.g., the multi-functional members 402 and 502 of FIG. 7 or 12) in an electronic device (e.g., the electronic device 1001, 1002, 1004, 100, or 200 of FIGS. 1 to 5) according to an embodiment of the disclosure. FIG. 15 is a view illustrating an assembly 600 taken along line B-B' of FIG. 14 in an electronic device 200 according to an embodiment of the disclosure.

Referring to FIGS. 14 and 15, the assembly 600 may include connection hole(s) 619a separate from the through holes 311a, 311b, and 311c. For example, the connection hole(s) 619a may be disposed around any one of the through holes 311a, 311b, and 311c, or between two adjacent through holes 311a, 311b, and 311c. In an embodiment, when the multi-functional member(s) 502a and 502b are disposed on the bracket 601, a portion of the flange (e.g., the flange 523 of FIG. 12) may be visually exposed from the inner surface of the bracket 601 through the connection hole(s) 619a. For example, the connection member (e.g., the second connection member 429c of FIG. 10) may be electrically connected to the multi-functional members 502a and 502b by contacting the flange. In this case, the flange(s) may be considered to be the conductive patterns. That is, the function of the conductive patterns may be performed by the flanges. In an embodiment, the conductive gasket 619b may be disposed in the connection hole(s) 619a on the inner surface of the bracket 601, thereby stably maintaining a contact state or an electrical connection state between the flange 523 and the connection member. In this case the conductive gasket and/or the flange(s) may be considered to be the conductive patterns. That is, the function of the conductive patterns may be performed by the conductive gasket and/or flanges. According to an embodiment, portions of the two adjacent multi-functional members 502a and 502b may be exposed to the inner surface of the bracket 601 through one connection hole 619a. For example, the plurality of multi-functional members 502a and 502b may be electrically connected to one conductive gasket 619b or one connection member.

In the illustrated embodiment, the connection hole(s) 619a are illustrated as having a substantially polygonal (e.g., square) shape, but it should be noted that the embodiment(s) of the disclosure are not limited thereto. For example, the connection hole(s) 619a may have a circular shape or a slot shape extending along the direction in which the through holes 311a, 311b, and 311c are arranged. When three multi-functional members 502a, 502b, and 502c are arranged in one direction, the two adjacent multi-functional members 502a and 502b and/or the three multi-functional members 502a, 502b, and 502c may be visually exposed on the inner surface of the bracket 601 through one connection hole(s) (e.g., slot). For example, one connection member and/or one conductive gasket 619b corresponding to a slot shape inside the bracket 601 may be electrically connected to the plurality of multi-functional members 502a and 502b.

Although not illustrated, the flanges and/or conductive gaskets may be arranged such that the first multi-functional member 502a and/or the third multi-functional member 502c are electrically connected to the first conductive pattern (and, optionally, to the second conductive pattern) and such that the second multi-functional member 502b is electrically connected to the second conductive pattern and not to the first conductive pattern (except, in some embodiments, via the first multi-functional member 502a and/or the third multi-functional member 502c).

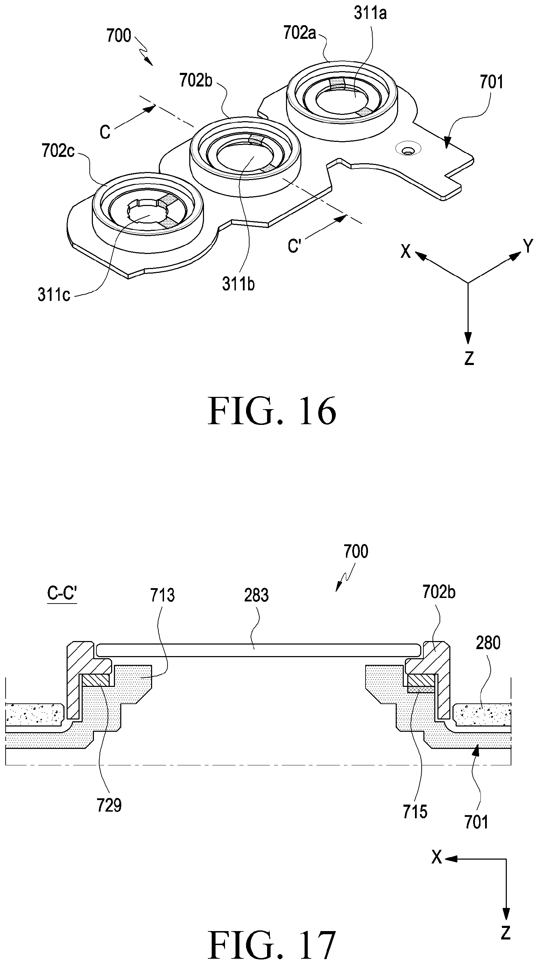

FIG. 16 is a perspective view illustrating a state in which a multi-functional member 702 (e.g., the multi-functional members 402 and 502 of FIG. 7 or FIG. 12) of an electronic device (e.g., the electronic device 1001, 1002, 1004, 100, or 200 of FIGS. 1 to 5) is disposed on a bracket 701 (e.g., the bracket 401, 501, or 601 of FIG. 7, FIG. 13, or FIG. 14) according to an embodiment of the disclosure. FIG. 17 is a view illustrating an assembly 700 taken along line C-C' of FIG. 16 in an electronic device 200 according to an embodiment of the disclosure.

In the assembly 700 of FIGS. 16 and 17, the conductive pattern(s) 715 may be formed at least partially on the surface of the binding rib 713 (e.g., the binding ribs 313a, 313b, and 313c of FIG. 7). For example, although a reference numeral is not assigned, the binding rib 713 may include a stepped surface or a shoulder portion formed on the outer circumferential surface, and at least a portion of the conductive pattern(s) 715 may be disposed on the stepped surface or the shoulder portion. In an embodiment, the multi-functional member 702 may be electrically connected to the conductive pattern(s) 715 by being coupled to surround the binding rib 713. In stably maintaining the electrical connection state between the multi-functional member 702 and the conductive pattern 715, the multi-functional assembly 700 may further include a connection member 729 (e.g., the first connection members 429a-1, 429a-2, 429b-1, 429b-2, and 429b-3 of FIG. 7) disposed around at least a portion of the circumference of the binding rib 713. For example, the connection member 729 may be disposed between the multi-functional member 702 and the conductive pattern 715 in a at least partially compressed state. In an embodiment, the connection member 729 may function as an adhesive member for fixing the multi-functional member 702 to the binding rib 713.

Although not illustrated, the conductive patterns 715 and/or connection members 729 may be arranged such that the first multi-functional member 702a and/or the third multi-functional member 702c are electrically connected to the first conductive pattern (and, optionally, to the second conductive pattern) and such that the second multi-functional member 702b is electrically connected to the second conductive pattern and not to the first conductive pattern (except, in some embodiments, via the first multi-functional member 702a and/or the third multi-functional member 702c).

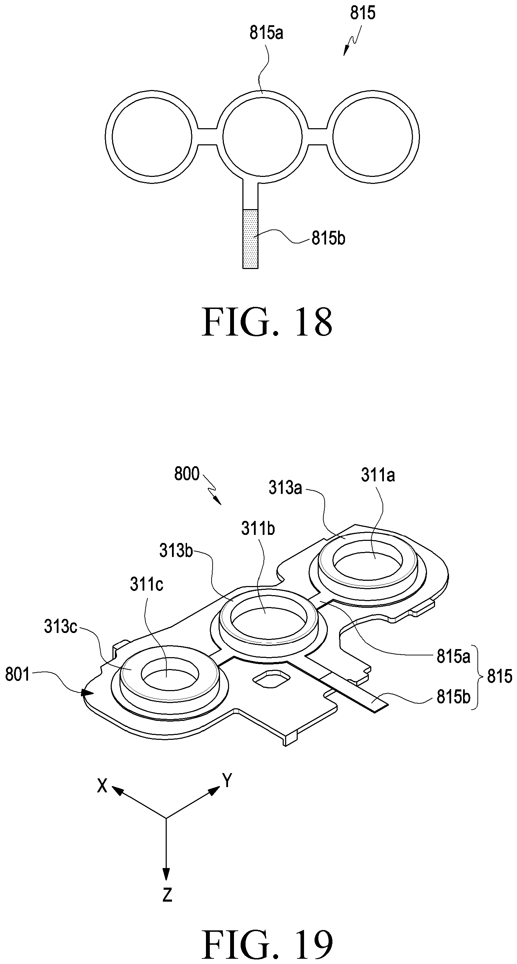

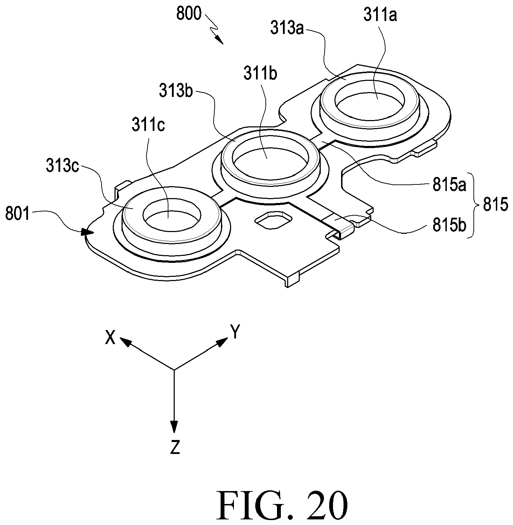

FIG. 18 is a view illustrating a conductive pattern(s) 815 (e.g., the conductive pattern(s) 415 of FIG. 7) of an electronic device (e.g., the electronic device 1001, 1002, 1004, 100, or 200 of FIGS. 1 to 5) according to an embodiment of the disclosure. FIG. 19 is a perspective view illustrating a state in which conductive pattern(s) 815 of an electronic device 200 are disposed on a bracket 801 according to an embodiment of the disclosure. FIG. 20 is a perspective view illustrating a state in which conductive pattern(s) 815 of an electronic device 200 are disposed on a bracket 801 according to an embodiment of the disclosure.

Referring to FIGS. 18 to 20, in the assembly 800, the conductive pattern(s) 815 may be implemented as a conductive tape. For example, the conductive pattern 815 may be a conductive tape including a contact portion(s) 815a disposed around the binding ribs 313a, 313b, and 313c and an extension 815b extending from the contact portion 815a. The contact portion 815a may be provided in a plurality of ring shapes to correspond to, e.g., the number of through holes 311a, 311b, and 311c or the number of binding ribs 313a, 313b, and 313c. For example, the contact portion 815a may be disposed around the through hole or the binding rib on one surface (e.g., the outer surface) of the bracket 801 (e.g., the bracket 401 of FIG. 7). In an embodiment, the contact portion 815a may be separated into a plurality of segments, similar to the conductive patterns 415 of FIG. 7. For example, the conductive pattern 815 of FIG. 18 may be separated into a first portion connected to the communication module (e.g., the communication module 1090 of FIG. 1) and a second portion connected to the ground portion, and a first multi-functional member and/or a third multi-functional member may be electrically connected to the first portion (and, optionally, to the second portion) and a second multi-functional member may be electrically connected to the second portion and not to the first portion (except, in some embodiments, via the first multi-functional member and/or the third multi-functional member). Each portion may have a separate extension.

According to an embodiment, the extension 815b may extend from the contact portion 815a on one surface of the bracket 801 to surround the side surface of the bracket 801, and a portion of the extension 815b may be disposed on the inner surface of the bracket 801. The "inner surface of the bracket 801" may refer to, e.g., a surface disposed to face the printed circuit board 240 of FIG. 4 or 5. For example, when the conductive pattern 815 is implemented as a conductive tape, the extension 815b may be partially disposed on the inner surface of the bracket 801, and a portion of the extension 815b may be electrically connected to the printed circuit board 240 on the inner surface of the bracket 801. When the conductive pattern(s) or the extension is connected to the printed circuit board, the second connection member 429c of FIG. 10 may be used.

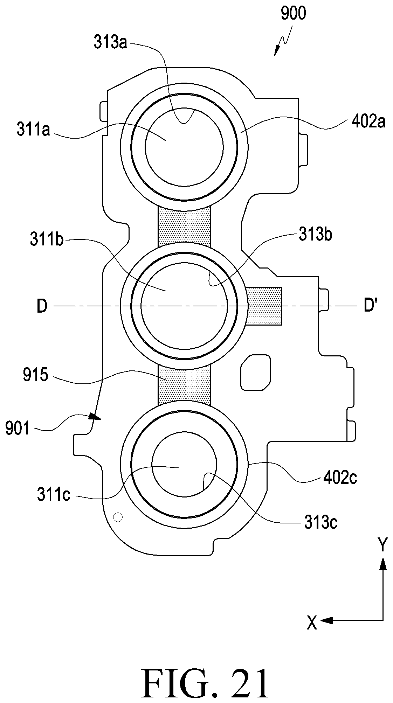

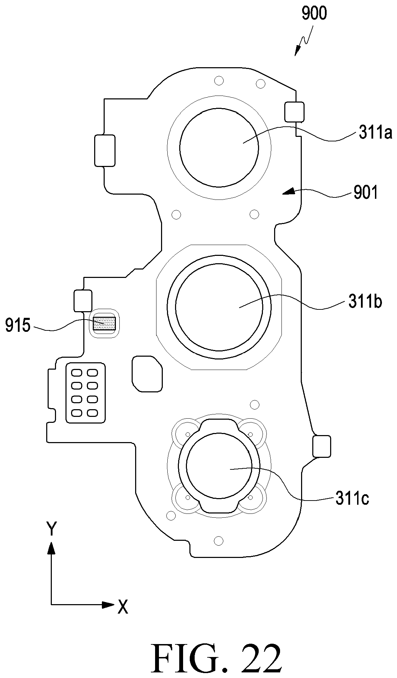

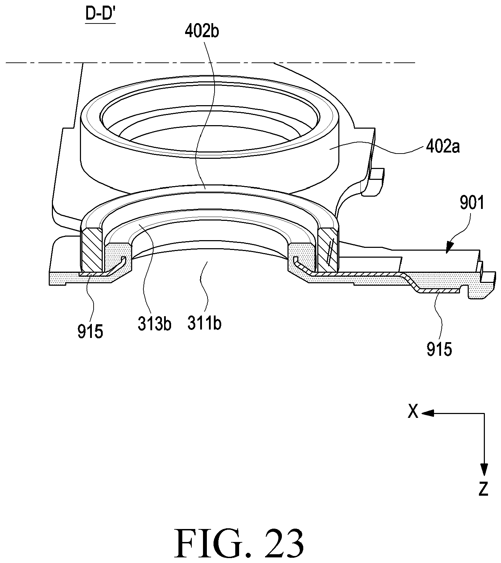

FIG. 21 is a plan view illustrating an outer surface of a bracket 901 (e.g., the bracket 401, 501, 601, 701, 801 of FIG. 7, 13, 14, 16, or 19) for disposing a multi-functional member (e.g., the multi-functional member 402, 502, or 702 of FIG. 7, 12, or 16) in an electronic device (e.g., the electronic device 1001, 1002, 1004, 100, or 200 of FIGS. 1 to 5) according to an embodiment of the disclosure. FIG. 22 is a plan view illustrating an inner surface of a bracket 901 for disposing a multi-functional member in an electronic device 200 according to an embodiment of the disclosure. FIG. 23 is a view illustrating an assembly 900 taken along line D-D' of FIG. 21 in an electronic device 200 according to an embodiment of the disclosure.

Referring to FIGS. 21 to 23, the assembly 900 may include a conductive pattern 915 implemented by a conductive plate member (for example, a stainless steel plate). The conductive pattern 915 implemented as a processed plate may be substantially embedded in the bracket 901, and a portion to come in contact with the multi-functional members 402a, 402b, and 402c or the connection member (e.g., the second connection member 429c of FIG. 10) may be exposed to the outside of the bracket 901. For example, as a portion of the conductive pattern 915 is exposed to the outside around the through holes 311a, 311b, and 311c or the binding ribs 313a, 313b, and 313c, the conductive pattern 915 may electrically contact at least one of the multi-functional members 402a, 402b, and 402c through the exposed portion. In an embodiment, the conductive pattern 915 may be exposed to the outside on the inner surface of the bracket 901, and may electrically contact the second connection member 429c on the inner surface of the bracket 901 when the second connection member 429c of FIG. 10 is disposed. In electrically contacting or connecting the conductive pattern 915 with the multi-functional members 402a, 402b, and 402c (or the second connection member 429c), the assembly 900 may further include a low-density elastic body such as a conductive gasket, thereby stably contacting or connecting the conductive pattern 915 with the multi-functional members 402a, 402b, and 402c and/or the conductive pattern 915 with the second connection member 429c. In an embodiment, the conductive pattern 915 may be exposed to the outside of the bracket 901 even if the conductive pattern 915 is not a portion to contact the multi-functional members 402a, 402b, and 402c or the second connection member 429c.

Although not illustrated, the conductive pattern 915 may comprise a first conductive pattern and a second conductive pattern and may be arranged such that the first multi-functional member 402a and/or the third multi-functional member 402c are electrically connected to the first conductive pattern (and, optionally, to the second conductive pattern) and such that the second multi-functional member 402b is electrically connected to the second conductive pattern and not to the first conductive pattern (except, in some embodiments, via the first multi-functional member 402a and/or the third multi-functional member 402c).

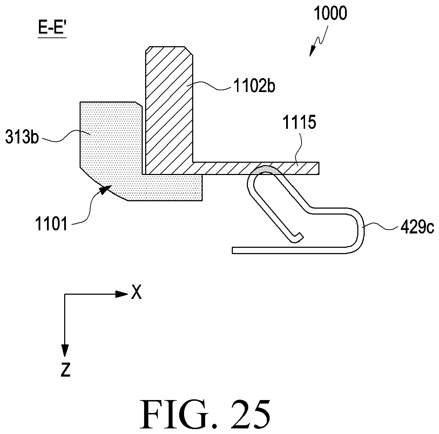

FIG. 24 is a plan view illustrating an outer surface of a bracket 1101 (e.g., the bracket 401, 501, 601, 701, 801, 901 of FIGS. 7, 13, 14, 16, 19, or 21) for disposing multi-functional members 1102a, 1102b, and 1102c (e.g., the multi-functional members 402, 502, and 702 of FIGS. 7, 12, or 16) in an electronic device (e.g., the electronic device 1001, 1002, 1004, 100, or 200 of FIGS. 1 to 5) according to an embodiment of the disclosure. FIG. 25 is a view illustrating an assembly 1100 taken along line E-E' of FIG. 24 in an electronic device 200 according to an embodiment of the disclosure.

Referring to FIGS. 24 and 25, the assembly 1100 may include contact piece(s) 1115 implementing a conductive pattern (e.g., the conductive pattern 415 of FIG. 7). The contact piece(s) 1115 may extend, e.g., from the outer circumferential surface of the multi-functional members 1102a, 1102b, and 1102c. In an embodiment, the bracket 1101 may include a connection hole (e.g., the connection hole 619a of FIG. 14) separate from the through holes 311a, 311b, and 311c. For example, when the multi-functional member(s) 1102a, 1102b, and 1102c are disposed on the outer surface of the bracket 1101, the contact piece(s) 1115 may be visually exposed on the inner surface of the bracket 1101. A structure in which the second connection member 429c (e.g., a C-clip) is disposed on the inner surface of the bracket 1101 and is electrically connected to the contact piece 1115 may be similar to the embodiment of FIG. 10 or 14, and thus a detailed description thereof will be omitted.

Although not illustrated, the contact pieces 1115 may be arranged to form a first conductive pattern and a second conductive pattern such that the first multi-functional member 1102a and/or the third multi-functional member 1102c are electrically connected to the first conductive pattern (and, optionally, to the second conductive pattern) and such that the second multi-functional member 1102b is electrically connected to the second conductive pattern and not to the first conductive pattern (except, in some embodiments, via the first multi-functional member 1102a and/or the third multi-functional member 1102c).

An electronic device (e.g., the electronic device 1001, 1002, 1004, 100, or 200 of FIGS. 1 to 5) according to an embodiment of the disclosure may include a multi-functional (e.g., the multi-functional members 402, 502, 702, 1102a, 1102b, and 1102c of FIGS. 7, 12, 16, or 24) formed of a metal or conductive material, thereby providing an electrostatic discharge path from the multi-functional member to the ground conductor (or a structure (e.g., the first supporting member 211 of FIG. 4 or 5) that functions as a ground portion), thereby suppressing electric shock to the user or damage to an electronic component due to static electricity. In an embodiment, when a plurality of multi-functional members are disposed, at least one multi-functional member may function as an antenna, thereby contributing to the expansion of the wireless communication function or the communication band of the electronic device. In an embodiment, when an electronic component (e.g., the camera assembly 207 of FIG. 4 or FIG. 5) processes or transmits high-speed/large-capacity data signals, a multi-functional member disposed adjacent to the corresponding electronic component may be connected to the ground portion without being connected to the communication module, thereby creating a stable operating environment of the electronic component. In an embodiment, the multi-functional member may also provide a protective structure to reinforce the mechanical strength of the electronic device in the vicinity of a through hole and/or protect a component (such as a camera) corresponding to the through hole. In an embodiment, the multi-functional member may also provide an aesthetically pleasing appearance.

Since the multi-functional members described herein may provide a number of advantageous functions (e.g. antenna function, discharge function, shielding function, protective function, and/or decorative function) they may be referred to as multi-functional members. Alternatively, they may be referred to as one or more of antenna members, discharge members, shielding members, protective members, conductive members, metal members, and/or decorative members.

Effects of the disclosure are not limited to the foregoing, and other unmentioned effects would be apparent to one of ordinary skill in the art from the description of the foregoing embodiment(s).

As described above, according to an embodiment of the disclosure, an electronic device (e.g., the electronic device 1001, 1002, 1004, 100, or 200 of FIGS. 1 to 5) may comprise a housing (e.g., the housing 201 of FIG. 4 or 5), a bracket (e.g., the bracket 401, 501, 601, 701, 801, 901, or 1101 of FIG. 7, 13, 14, 16, 19, or 21) providing through holes (e.g., the through hole 311 of FIG. 7) and disposed inside the housing, a first conductive pattern (e.g., the first conductive pattern 415a of FIG. 7) disposed on the bracket, a second conductive pattern (e.g., the second conductive pattern 415b of FIG. 7) disposed on the bracket, and multi-functional members (e.g., the multi-functional member 402, 502, 702, 1102a, 1102b, or 1102c of FIG. 7, 12, 16, or 24) disposed around any one of the through holes and at least partially visually exposed to an outside of the housing. In an embodiment, a first multi-functional member (e.g., the first multi-functional member 402a or the third multi-functional member 402c of FIG. 7) among the multi-functional members may be electrically connected to the first conductive pattern and the second conductive pattern, and a second multi-functional member (e.g., the second multi-functional member 402b of FIG. 7) among the multi-functional members may be electrically connected to the second conductive pattern and be not electrically connected to the first conductive pattern.

According to an embodiment, the first multi-functional member may be electrically connected to a communication module (e.g., the communication module 1090 of FIG. 1) of the electronic device through the first conductive pattern and electrically connected to a ground unit (e.g., the ground conductor provided in the printed circuit board 240 of FIG. 4 or 5 or the first supporting member 211) of the electronic device through the second conductive pattern to be configured to transmit/receive a wireless signal. In an embodiment, the second multi-functional member may be electrically connected to the ground unit of the electronic device through the second conductive pattern.

According to an embodiment, the electronic device may further comprise a first camera (e.g., any one of the cameras included in the camera assembly 207 of FIG. 4 or 5) configured to obtain a subject image through a through hole (e.g., the first through hole 311a or third through hole 311c of FIG. 7) corresponding to the first multi-functional member among the through holes. The first camera may be any one of, e.g., a telephoto camera, a macro camera, or a depth camera.

According to an embodiment, the first multi-functional member may be electrically connected to a communication module of the electronic device through the first conductive pattern and electrically connected to a ground unit of the electronic device through the second conductive pattern to be configured to transmit/receive a wireless signal.

According to an embodiment, the electronic device may further comprise a wide-angle camera (e.g., another one among the cameras included in the camera assembly 207 of FIG. 4 or 5) configured to obtain a subject image through a through hole (e.g., the second through hole 311b of FIG. 7) corresponding to the second multi-functional member among the through holes. In an embodiment, the second multi-functional member may be electrically connected to the ground unit of the electronic device through the second conductive pattern.

According to an embodiment, the multi-functional members have a closed loop shape.

According to an embodiment, the first conductive pattern or the second conductive pattern may include any one of a laser direct structuring (LDS) pattern, at least a portion of a conductive plate member, or a conductive tape.

According to an embodiment, the electronic device may further comprise a first connection member (e.g., the first connection member 429a-1, 429a-2, 429b-1, 429b-2, or 429b-3 of FIG. 7) disposed on the bracket to contact the first conductive pattern or the second conductive pattern. In an embodiment, the first multi-functional member or the second multi-functional member may be disposed on the bracket to be configured to electrically contact the first connection member.

According to an embodiment, the electronic device may further comprise a binding rib (e.g., the binding rib 313a, 313b, or 313c of FIG. 7) formed around the through hole on one surface of the bracket, a binding recess (e.g., the binding recess 417 of FIG. 7 or 11) formed on an outer circumferential surface of the binding rib, and a binding protrusion (e.g., the binding protrusion 421a, 421b, or 421c of FIG. 7) protruding from an inner circumferential surface of the first multi-functional member or the second multi-functional member. In an embodiment, the first multi-functional member or the second multi-functional member may be configured to be fixed on the bracket as the binding protrusion is engaged to the binding recess.

According to an embodiment, the first conductive pattern or the second conductive pattern may include a flange (e.g., the flange 523 of FIG. 12) or a contact piece (e.g., the contact piece 1115 of FIG. 24) extending from the first multi-functional member or the second multi-functional member.

According to an embodiment, the electronic device may further comprise a second connection member (e.g., the second connection member 429c of FIG. 10) disposed on an inner surface of the bracket. In an embodiment, the first multi-functional member or the second multi-functional member may be disposed on an outer surface of the bracket, and at least a portion of the flange or the contact piece may be exposed to an inner surface of the bracket to be configured to electrically contact the second connection member.

According to an embodiment, the second connection member may include a conductive gasket or a leaf spring.

According to an embodiment, the first conductive pattern or the second conductive pattern may include a conductive tape. In an embodiment, the conductive tape may include a contact portion (e.g., the contact portion 815a of FIG. 18) disposed on an outer surface of the bracket to contact the first multi-functional member or the second multi-functional member and an extension (e.g., the extension 815b of FIG. 18) extending from the contact portion to be partially disposed to an inner surface of the bracket while surrounding a side surface of the bracket.

According to an embodiment of the disclosure, an electronic device (e.g., the electronic device 1001, 1002, 1004, 100, or 200 of FIGS. 1 to 5) may comprise a housing (e.g., the housing 201 of FIG. 4 or 5), a communication module (e.g., the communication module 1090 of FIG. 1), a bracket (e.g., the bracket 401, 501, 601, 701, 801, 901, or 1101 of FIG. 7, 13, 14, 16, 19, or 21) providing through holes (e.g., the through hole 311 of FIG. 7) and disposed inside the housing, a first conductive pattern (e.g., the first conductive pattern 415a of FIG. 7) disposed on the bracket, a second conductive pattern (e.g., the second conductive pattern 415b of FIG. 7) disposed on the bracket, and multi-functional members (e.g., the multi-functional member 402, 502, 702, 1102a, 1102b, or 1102c of FIG. 7, 12, 16, or 24) disposed around any one of the through holes and at least partially visually exposed to an outside of the housing. In an embodiment, a first multi-functional member (e.g., the first multi-functional member 402a or the third multi-functional member 402c of FIG. 7) among the multi-functional members may be electrically connected to the communication module through the first conductive pattern to be configured to perform wireless communication, and a second multi-functional member (e.g., the second multi-functional member 402b of FIG. 7) among the multi-functional members may be electrically connected to a ground unit (e.g., the ground conductor provided in the printed circuit board 240 of FIG. 4 or 5 or the first supporting member 211) of the electronic device through the second conductive pattern and not electrically connected to the first conductive pattern.

According to an embodiment, the electronic device may further comprise a wide-angle camera (e.g., any one among the cameras included in the camera assembly 207 of FIG. 4 or 5) configured to obtain a subject image through a through hole (e.g., the second through hole 311b of FIG. 7) corresponding to the second multi-functional member among the through holes. In an embodiment, the second multi-functional member may be electrically connected to the ground unit of the electronic device through the second conductive pattern.

According to an embodiment, the first conductive pattern or the second conductive pattern may include any one of a laser direct structuring (LDS) pattern, at least a portion of a conductive plate member, or a conductive tape.

According to an embodiment, the electronic device may further comprise a first connection member (e.g., the first connection member 429a-1, 429a-2, 429b-1, 429b-2, or 429b-3 of FIG. 7) disposed on the bracket to contact the first conductive pattern or the second conductive pattern. In an embodiment, the first multi-functional member or the second multi-functional member may be disposed on the bracket to be configured to electrically contact the first connection member.

According to an embodiment, the through holes may include a first through hole (e.g., the first through hole 311a of FIG. 7), a second through hole (e.g., the second through hole 311b of FIG. 7), and a third through hole (e.g., the third through hole 311c of FIG. 7) sequentially disposed in one direction. In an embodiment, the second multi-functional member may be disposed around the second through hole.

According to an embodiment, a plurality of first multi-functional members may be provided and disposed around the first through hole and the third through hole.

According to an embodiment, the electronic device may further comprise a wide-angle camera (e.g., any one among the cameras included in the camera assembly 207 of FIG. 4 or 5) configured to obtain a subject image through the second through hole.

In a first example, there is provided an electronic device (e.g., the electronic device 1001, 1002, 1004, 100, or 200 of FIGS. 1 to 5) comprising: a housing (e.g., the housing 201 of FIG. 4 or 5), a bracket (e.g., the bracket 401, 501, 601, 701, 801, 901, or 1101 of FIG. 7, 13, 14, 16, 19, or 21) disposed inside the housing and comprising a plurality of through holes (e.g., the through hole 311 of FIG. 7) including a first through hole and a second through hole, a first conductive pattern (e.g., the first conductive pattern 415a of FIG. 7) disposed on the bracket, a second conductive pattern (e.g., the second conductive pattern 415b of FIG. 7) disposed on the bracket, and a plurality of multi-functional members (e.g., the multi-functional member 402, 502, 702, 1102a, 1102b, or 1102c of FIG. 7, 12, 16, or 24) including a first multi-functional member corresponding to the first through hole and a second multi-functional member corresponding to the second through hole; wherein the first multi-functional member (e.g., the first multi-functional member 402a or the third multi-functional member 402c of FIG. 7) is electrically connected to the first conductive pattern, and wherein the second multi-functional member (e.g., the second multi-functional member 402b of FIG. 7) is electrically connected to the second conductive pattern.

In a second example, there is provided the electronic device of the first example, wherein each of the plurality of multi-functional members is at least partially visually exposed to an outside of the housing.

In a third example, there is provided the electronic device of the first or second example, wherein each of the plurality of multi-functional members is disposed around a corresponding through hole among the plurality of through holes.

In a fourth example, there is provided the electronic device of any preceding example, wherein the first multi-functional member is electrically connected to the second conductive pattern.

In a fifth example, there is provided the electronic device of any preceding example, wherein the second multi-functional member is not electrically connected to the first conductive pattern.

In a sixth example, there is provided the electronic device of any of the first to fourth examples, wherein the second multi-functional member is not electrically connected to the first conductive pattern except via the first multi-functional member and/or at least one other multi-functional member among the multi-functional members.

In a seventh example, there is provided the electronic device of any preceding example, wherein the first multi-functional member is electrically connected to a communication module (e.g., the communication module 1090 of FIG. 1) of the electronic device through the first conductive pattern, wherein the first multi-functional member is configured to transmit/receive a wireless signal.

In an eighth example, there is provided the electronic device of any of the fourth to seventh examples, wherein the first multi-functional member is electrically connected to a ground unit (e.g., the ground conductor provided in the printed circuit board 240 of FIG. 4 or 5 or the first supporting member 211) of the electronic device through the second conductive pattern.

In a ninth example, there is provided the electronic device of any preceding example, wherein the second multi-functional member is electrically connected to the ground unit of the electronic device through the second conductive pattern.

In a tenth example, there is provided the electronic device of any preceding example, further comprising a first camera (e.g., any one of the cameras included in the camera assembly 207 of FIG. 4 or 5) configured to obtain a subject image through the first through hole (e.g., the first through hole 311a or third through hole 311c of FIG. 7), wherein the first camera is at least one of a telephoto camera, a macro camera, or a depth camera.

In an eleventh example, there is provided the electronic device of any preceding example, further comprising a wide-angle camera (e.g., another one among the cameras included in the camera assembly 207 of FIG. 4 or 5) configured to obtain a subject image through the second through hole (e.g., the second through hole 311b of FIG. 7).

In a twelfth example, there is provided the electronic device of any preceding example, wherein the multi-functional members have a closed loop shape.

In a thirteenth example, there is provided the electronic device of any preceding example, wherein at least one of the first conductive pattern or the second conductive pattern includes any a laser direct structuring (LDS) pattern, at least a portion of a conductive plate member, a conductive tape, and/or a connecting piece or flange of at least one of the first multi-functional member or the second multi-functional member.

In a fourteenth example, there is provided the electronic device of any preceding example, further comprising a first connection member (e.g., the first connection member 429a-1, 429a-2, 429b-1, 429b-2, or 429b-3 of FIG. 7) disposed on the bracket to contact the first conductive pattern or the second conductive pattern, wherein at least one of the first multi-functional member or the second multi-functional member is configured to electrically contact the first connection member.

In a fifteenth example, there is provided the electronic device of any preceding example, further comprising a binding rib (e.g., the binding rib 313a, 313b, or 313c of FIG. 7) formed around the first through hole or second through hole on one surface of the bracket, a binding recess (e.g., the binding recess 417 of FIG. 7 or 11) formed on an outer circumferential surface of the binding rib, and a binding protrusion (e.g., the binding protrusion 421a, 421b, or 421c of FIG. 7) protruding from an inner circumferential surface of the first multi-functional member or the second multi-functional member. In an embodiment, the first multi-functional member or the second multi-functional member may be configured to be fixed on the bracket as the binding protrusion is engaged to the binding recess.

In a sixteenth example, there is provided the electronic device of any preceding example, wherein at least one of the first conductive pattern or the second conductive pattern includes a flange (e.g., the flange 523 of FIG. 12) or a contact piece (e.g., the contact piece 1115 of FIG. 24) extending from at least one of the first multi-functional member or the second multi-functional member.

In a seventeenth example, there is provided the electronic device of the sixteenth example, further comprising a second connection member (e.g., the second connection member 429c of FIG. 10) disposed on an inner surface of the bracket, wherein at least one of the first multi-functional member or the second multi-functional member is disposed on an outer surface of the bracket, and at least a portion of the flange or the contact piece may be exposed to an inner surface of the bracket and configured to electrically contact the second connection member.

In an eighteenth example, there is provided the electronic device of the seventeenth example, wherein the second connection member includes a conductive gasket or a leaf spring.

In a nineteenth example, there is provided the electronic device of any preceding example, wherein at least one of the first conductive pattern or the second conductive pattern may include a conductive tape, and wherein the conductive tape may include a contact portion (e.g., the contact portion 815a of FIG. 18) disposed on an outer surface of the bracket to contact the first multi-functional member or the second multi-functional member and an extension (e.g., the extension 815b of FIG. 18) extending from the contact portion to be partially disposed on an inner surface of the bracket while surrounding a side surface of the bracket.

In a twentieth example, there is provided the electronic device of any preceding claim, wherein the plurality of through holes further includes a third through hole (e.g., the third through hole 311c of FIG. 7), wherein the first through hole, the second through hole, and the third through hole are sequentially disposed in one direction.

In a twenty-first example, there is provided the electronic device of the twentieth example, wherein the plurality of multi-functional members further includes a third multi-functional member corresponding to the third through hole.

In a twenty-second example, there is provided the electronic device of the twenty-first example, wherein the third multi-functional member is electrically connected to the second conductive pattern.

In a twenty-third example, there is provided the electronic device of the twenty-first or twenty-second examples, wherein the second multi-functional member is not electrically connected to the first conductive pattern except via the first multi-functional member and/or the third multi-functional member and/or at least one other multi-functional member among the multi-functional members.

In a twenty-fourth example, there is provided the electronic device of any of the twenty-first to twenty-third example, wherein the third multi-functional member is electrically connected to a communication module (e.g., the communication module 1090 of FIG. 1) of the electronic device through the first conductive pattern, wherein the third multi-functional member is configured to transmit/receive a wireless signal.

In a twenty-fifth example, there is provided the electronic device of any of the twenty-first to twenty-fourth examples, wherein the third multi-functional member is electrically connected to a ground unit (e.g., the ground conductor provided in the printed circuit board 240 of FIG. 4 or 5 or the first supporting member 211) of the electronic device through the second conductive pattern.

While the disclosure has been described and shown in connection with an embodiment thereof, it should be appreciated that an embodiment is intended as limiting the invention but as illustrative. It will be apparent to one of ordinary skill in the art that various changes may be made in form and detail without departing from the overall scope of the disclosure, including the appended claims and their equivalents.

## Claims

1. An electronic device (1001; 1002; 1004; 100; 200) comprising:
a housing (201);
a bracket (401; 501; 601; 701; 801; 901; 1101) disposed inside the housing and comprising a plurality of through holes (311: 311a, 311b, 311c) including a first through hole and a second through hole;
a first conductive pattern (415a) disposed on the bracket;
a second conductive pattern (415b) disposed on the bracket; and
a plurality of multi-functional members (402; 502; 702; 1102a, 1102b, 1102c) at least partially visually exposed to an outside of the housing,
wherein a first multi-functional member (402a, 402c) among the multi-functional members is disposed around the first through hole and is electrically connected to the first conductive pattern and the second conductive pattern, and
wherein a second multi-functional member (402b) among the multi-functional members is disposed around the second through hole, is electrically connected to the second conductive pattern, and is not electrically connected to the first conductive pattern except via the first multi-functional member and/or at least one other multi-functional member among the multi-functional members.

2. The electronic device of claim 1, wherein the first multi-functional member is electrically connected to a communication module (1090) of the electronic device through the first conductive pattern and is electrically connected to a ground portion of the electronic device through the second conductive pattern and is configured to transmit/receive a wireless signal, and
wherein the second multi-functional member is electrically connected to the ground portion of the electronic device through the second conductive pattern.

3. The electronic device of claim 1 or 2, further comprising:
a first camera configured to obtain a subject image through the first through hole,
wherein the first camera is at least one of a telephoto camera, a macro camera, or a depth camera.

4. The electronic device of claim 3, wherein the first multi-functional member is electrically connected to a communication module of the electronic device through the first conductive pattern and electrically connected to a ground portion of the electronic device through the second conductive pattern and is configured to transmit/receive a wireless signal.

5. The electronic device of any one of claims 1 to 4, further comprising:
a wide-angle camera configured to obtain a subject image through the second through hole,
wherein the second multi-functional member is electrically connected to the ground portion of the electronic device through the second conductive pattern.

6. The electronic device of any one of claims 1 to 5, wherein the multi-functional members have a closed loop shape.

7. The electronic device of any one of claims 1 to 6, wherein at least one of the first conductive pattern or the second conductive pattern includes at least one of a laser direct structuring (LDS) pattern, at least a portion of a conductive plate member, or a conductive tape.

8. The electronic device of any one of claims 1 to 7, further comprising:
a first connection member (429a-1, 429a-2, 429b-1, 429b-2, 429b-3) disposed on the bracket to contact the first conductive pattern or the second conductive pattern,
wherein the first multi-functional member or the second multi-functional member is configured to electrically contact the first connection member.

9. The electronic device of any one of claims 1 to 8, further comprising:
a binding rib (313a, 313b, 313c; 713) formed around the first through hole or the second through hole on one surface of the bracket;
a binding recess (417: 417a, 417b) formed on an outer circumferential surface of the binding rib; and
a binding protrusion (421a, 421b, 421c) protruding from an inner circumferential surface of the first multi-functional member or the second multi-functional member,
wherein the first multi-functional member or the second multi-functional member is configured to be fixed on the bracket as the binding protrusion is engaged to the binding recess.

10. The electronic device of any one of claims 1 to 9, wherein at least one of the first conductive pattern or the second conductive pattern includes a flange (523) or a contact piece (1115) extending from at least one of the first multi-functional member or the second multi-functional member.

11. The electronic device of claim 10, further comprising:
a second connection member (429c) disposed on an inner surface of the bracket,
wherein at least one of the first multi-functional member or the second multi-functional member is disposed on an outer surface of the bracket, and wherein at least a portion of the flange or the contact piece is exposed to an inner surface of the bracket and configured to electrically contact the second connection member.

12. The electronic device of claim 11, wherein the second connection member includes a conductive gasket or a leaf spring.

13. The electronic device of any one of claims 1 to 12, wherein at least one of the first conductive pattern or the second conductive pattern includes a conductive tape, and
wherein the conductive tape includes a contact portion (815a) disposed on an outer surface of the bracket to contact the first multi-functional member or the second multi-functional member and an extension (815b) extending from the contact portion to be partially disposed on an inner surface of the bracket while surrounding a side surface of the bracket.

14. The electronic device (1001; 1002; 1004; 100; 200) of any one of claims 1 to 13, further comprising:
a communication module (1090),
wherein the first multi-functional member (402a, 402c) is electrically connected to the communication module through the first conductive pattern, and is configured to perform wireless communication, and
wherein the second multi-functional member (402b) is electrically connected to a ground portion of the electronic device through the second conductive pattern.

15. The electronic device of claim 14, wherein the plurality of through holes include the first through hole (311a), the second through hole (311b), and a third through hole (311c) sequentially disposed in one direction, and the second multi-functional member is disposed around the second through hole,
wherein a plurality of first multi-functional members are provided and are disposed around the first through hole and the third through hole, and
wherein the electronic device further comprises a wide-angle camera configured to obtain a subject image through the second through hole.
